(19) Europäisches Patentamt / European Patent Office / Office européen des brevets

(11) **EP 4 488 227 A1**

(12) **EUROPEAN PATENT APPLICATION**


(43) Date of publication:
**08.01.2025 Bulletin 2025/02**

(21) Application number: **24165545.5**

(22) Date of filing: **22.03.2024**

(51) International Patent Classification (IPC):
***C01B 32/05*** (2017.01) ***B82Y 30/00*** (2011.01)
***B82Y 40/00*** (2011.01) ***C01B 32/312*** (2017.01)
***C01B 32/33*** (2017.01) ***C01B 32/348*** (2017.01)
***C01B 33/027*** (2006.01) ***H01M 4/04*** (2006.01)
***H01M 4/36*** (2006.01) ***H01M 4/38*** (2006.01)
***H01M 4/587*** (2010.01) ***H01M 4/62*** (2006.01)
***H01M 10/0525*** (2010.01) ***H01M 4/583*** (2010.01)
*H01M 4/02* (2006.01)

(52) Cooperative Patent Classification (CPC):
**C01B 32/312; B82Y 30/00; B82Y 40/00; C01B 32/05; C01B 32/33; C01B 32/348; C01B 33/027; H01M 4/0428; H01M 4/0471; H01M 4/362; H01M 4/366; H01M 4/386; H01M 4/583; H01M 4/587; H01M 4/625;** (Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **06.07.2023 KR 20230087453**



(71) Applicant: **SK Innovation Co., Ltd.**
**Seoul 03188 (KR)**

(72) Inventors:
- **YUN, Dongmin**
  **34124 Daejeon (KR)**
- **LEE, Ji Hoon**
  **34124 Daejeon (KR)**
- **JANG, Jung Geun**
  **34124 Daejeon (KR)**

(74) Representative: **Frick, Robert**
**Lorenz Seidler Gossel**
**Rechtsanwälte Patentanwälte**
**Partnerschaft mbB**
**Widenmayerstraße 23**
**80538 München (DE)**


(54) **SILICON-CARBON COMPOSITES CONTAINING CARBON DERIVED FROM METHANE PYROLYSIS AND USE THEREOF**


(57) The present invention relates to a silicon-carbon (Si/C) composite that is prepared by combining silicon with a porous carbon-based material, which is obtained by removing iron impurities from solid carbon produced during pyrolysis for converting a methane-containing feedstock into hydrogen in the presence of an iron-based catalyst. The present invention further relates to a method for making the silicon-carbon (Si/C) composite and a use thereof as electrode material.


**Fig. 13**

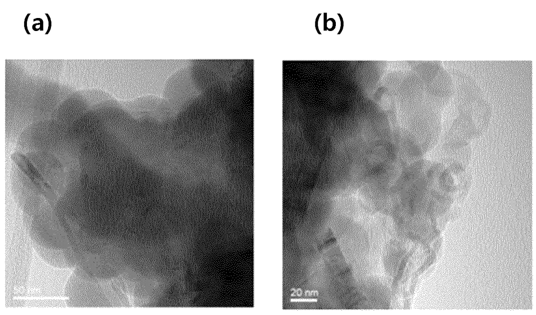


EP 4 488 227 A1

(52) Cooperative Patent Classification (CPC): (Cont.)
**H01M 10/0525;** C01P 2006/12; C01P 2006/14;
C01P 2006/16; H01M 2004/021; H01M 2004/027

## Description

BACKGROUND OF THE INVENTION

Field of the Invention

The present invention relates to a silicon-carbon composite containing carbon derived by catalytic methane pyrolysis and the use thereof. More specifically, the present invention relates to a silicon-carbon (Si/C) composite that is prepared by combining silicon with a porous carbon-based material obtained by removing iron impurities from solid carbon produced during pyrolysis for converting a methane-containing feedstock into hydrogen in the presence of an iron-based catalyst and the use thereof as electrode material.

Description of the Related Art

Methane is the most abundant compound in natural gas, and accounts for twice the amount of carbon as other known fossil fuel sources. Specifically, it has been reported that natural gas reserves are more extensive than those of coal and oil put together. With the gradual depletion of coal and oil reserves, utilization of natural gas is having a significant impact on the global energy balance. Hence, supply of natural gas such as methane is expected to last for more than 20 years longer than petroleum resources, and thus natural gas is emerging as the most realistic alternative raw material to replace petroleum in the era of depletion of petroleum resources and high oil prices. Accordingly, research is being actively conducted to produce high valueadded materials, especially hydrogen, from methane. In particular, the value of hydrogen as a clean energy source has recently been increasing because it has high energy efficiency per unit mass and produces only water without other harmful by-products during combustion.

There are known methods for producing high-value substances, especially hydrogen, from methane, such as oxidative or non-oxidative coupling reaction of methane ($CH_4 \rightarrow 1/6C_6H_6 + 9/6H_2$; $CH_4 \rightarrow 1/2C_2H_4 + H_2$), steam reforming reaction of methane ($CH_4 + H_2O \rightarrow CO + 3H_2$), and partial oxidation reaction of methane ($CH_4 + 1/2O_2 \rightarrow CO + 2H_2$) (e.g., Korean Patent Laid-open No. 2018-0113448, and the like). However, these reactions disadvantageously require a large amount of energy input due to highly endothermic reaction characteristics and cause emission of $CO_2$ as a by-product. As an alternative thereto, a process has been developed to produce hydrogen from methane through pyrolysis using a catalyst, for example, a ferric oxide ($Fe_2O_3$) catalyst. This reaction route is advantageous in that it does not involve production of carbon dioxide and produces only carbon as a by-product other than hydrogen (e.g., Int. J. Hydrogen Energy, Vol. 18, No. 3, pp. 211-215). In particular, hydrogen has high utility in that it can convert carbon dioxide emitted from industrial processes into other important platform chemicals.

The solid carbon produced along with hydrogen in the pyrolysis of methane has different forms and structures depending on the pyrolysis method. In order to improve the economic feasibility of hydrogen production, recent efforts have been recently made to use carbon to create higher added value.

For example, carbon may be present in various forms. Among them, carbon black can be used as a filler, a reinforcing agent, or a coating performance improver of printing ink for tires, rubber, and various plastic products. In particular, research is being actively conducted on the use of carbon as an electrode material (e.g., anode) for batteries such as lithium-ion batteries. It has been reported that nanocarbon materials can improve battery performance (e.g., energy efficiency and output capacity). In this regard, forms of carbon, such as graphite/graphene, carbon fiber precursors, and carbon nanotubes (CNTs), other than carbon black, are known. The type of carbon produced by the methane conversion depends on the reaction characteristics or mechanism, the catalyst, or the like.

The pyrolysis of methane is typically performed using a catalyst, and in this case, the carbon product is separated and recovered after deposition on the catalyst. As such, the carbon product produced during the methane conversion contains impurities derived from the catalyst and thus is directly inapplicable to various high-value fields.

Meanwhile, it has been known to use a composite of carbon with a metal component rather than carbon alone as an anode material in order to further improve the performance of lithium-ion batteries. In this case, a representative metal is silicon (Si), which has a high theoretical capacity of 4,200 mAh/g. However, when carbon is completely replaced by silicon, volume changes and low conductivity during cycle are problematic. In particular, when silicon expands in volume during cycle, as the electrolyte decomposes on the silicon surface, battery capacity continues to decrease due to continuous consumption of lithium ions. In consideration of this, Si/C composites for electrode materials have been developed in an attempt to combine the high conductivity and small volume change characteristics of carbon with the high capacity of silicon (Nanoscale 6 371- 7 (2014), etc.).

However, the prior art does not disclose producing electrode materials based on carbon-based materials produced during methane pyrolysis, for example, carbon-based materials containing the pyrolysis catalyst as impurities.

## SUMMARY OF THE INVENTION

The present invention aims to provide a method of preparing high-value materials using low-value carbon products obtained during methane pyrolysis in the presence of an iron-based catalyst.

The present invention further aims to provide a silicon-carbon (Si/C) composite that exhibits improved electrode performance compared to commercial carbon-based materials.

Against this background, the present invention relates to a method for preparing a silicon-carbon (Si/C) composite, wherein the method comprises:

a) providing solid iron-containing carbon separated from a product of methane pyrolysis performed in the presence of an iron-based catalyst,
b) removing iron as an impurity from the solid iron-containing carbon by heat treatment to form a porous carbon-based material having increased micropore and mesopore volumes and an increased macropore size, and
c) attaching silicon to the porous carbon-based material formed in step b).

In an embodiment, a content of the iron (on an elemental basis) in the iron-containing carbon may be within a range of 0.1 to 20% by weight.

In an embodiment, the heat treatment in step b) may be performed at a temperature of at least 1,600°C and at an atmospheric pressure or lower.

In an embodiment, step a) may comprise:

subjecting a methane-containing feedstock to pyrolysis in the presence of an iron-containing catalyst in the form of solid particles to form (i) a gas mixture containing hydrogen and (ii) solid iron-containing carbon as a combination of carbon produced by the pyrolysis with iron derived from the iron-based catalyst, and
separating the solid iron-containing carbon from the gas mixture.

In an embodiment, step a) may comprise:

a1) introducing the methane-containing feedstock along with the iron oxide-containing catalyst in the form of solid particles into a rotary kiln-type reactor to form a pyrolysis product containing unreacted methane, carbon, hydrogen and carbon monoxide, and
a2) separating the gas mixture containing unreacted methane, hydrogen and carbon monoxide, and the solid iron-containing carbon, respectively through gas-solid phase separation.

In an embodiment, the methane-containing feedstock and the iron oxide-containing catalyst in the form of solid particles may be introduced into the rotary kiln-type reactor in a co-current flow manner.

In an embodiment, the rotary kiln-type reactor may comprise:

a tube configured to accommodate solid particles and gas and to be rotatable;
a heater configured to supply controlled heat to an inner space of the tube;
a helix baffle configured to extend along an inner circumferential surface of the tube to induce the introduced iron oxide-containing catalysts in the form of solid particles to move forward in a longitudinal direction of the tube according to rotation of the tube; and
at least one lifter provided on the inner circumferential surface of the tube to disperse the introduced iron oxide-containing catalysts in the form of solid particles in the tube.

In an embodiment, the iron oxide-containing catalyst in the form of solid particles may have an apparent density of 0.8 to 2.8 g/$cm^3$ and the solid iron-containing carbon may have an apparent density of 0.05 to 0.5 g/$cm^3$.

The present invention further relates to a silicon-carbon (Si/C) composite, which comprises:

a porous carbon-based material having an iron content of 20 mg/kg or less and having micropores, mesopores, and macropores, and
silicon attached to the porous carbon-based material,
wherein the porous carbon-based material has a graphite-type carbon structure,
a pore volume of the micropores and mesopores having a size in the range of 1.5 to 50 nm is within a range of 0.08 to 0.25 $cm^3$/g.

In an embodiment, a pore volume of macropores having a size within the range of 65 to 250 nm may be at least 0.1

$cm^3/g$.

In an embodiment, the micropores and the mesopores may comprise a primary pore and a secondary pore, wherein a size of the primary pore is within a range of 1.5 to 3.5 nm and a size of the secondary pore is within a range of 3.5 to 50 nm.

In an embodiment, a ratio of $I_D/I_G$ of the porous carbon-based material upon Raman spectroscopy may be within a range of 1 or less.

In an embodiment, a content of silicon in the silicon-carbon (Si/C) composite may be adjusted within a range of 10 to 70% by weight.

Yet further, the present invention relates to an electrode material comprising the silicon-carbon (Si/C) composite according to the invention.

In an embodiment, the electrode material is anode material for batteries.

## BRIEF DESCRIPTION OF THE DRAWINGS

The above and other objects, and features of the present invention will be more clearly understood from the following detailed description taken in conjunction with the accompanying drawings, in which:

FIG. 1 schematically shows a single process for producing hydrogen, carbon monoxide, and a carbon-based material from a methane-containing feedstock according to an embodiment;

FIG. 2 shows the overall structure of a rotary kiln-type reactor applicable to pyrolysis of a methane-containing feedstock according to an embodiment;

FIGS. 3A to 3C, respectively, are a perspective view, a combination of a side view and a plan view, and a front view showing a combination of a helix baffle and lifters (one lifter per pitch) on the inner circumferential surface of a tube of a rotary kiln-type reactor according to an embodiment;

FIG. 4 schematically shows a process in which catalyst particles are divided by lifters in the tube of the rotary kiln-type reactor having a combination of a helix baffle and lifters;

FIGS. 5A to 5C, respectively, are a perspective view, a combination of a side view and a plan view, and a front view showing a combination of a helix baffle and lifters (four lifters per pitch) on the inner circumferential surface of a tube of a rotary kiln-type reactor according to another embodiment;

FIGS. 6A to 6C, respectively, are front views showing various examples of lifter shapes in the tube of a rotary kiln-type reactor;

FIG. 7 is a graph showing methane conversion depending on TOS (time on stream) in Methane Pyrolysis 1 of Examples;

FIG. 8 is a graph showing methane conversion depending on TOS (time on stream) in Methane Pyrolysis 2 of Examples;

FIGS. 9A and 9B, respectively, illustrate XRD patterns before and after heat treatment (at 1,800°C for 6 hours) of solid iron-containing carbon obtained by methane pyrolysis;

FIGS. 10A and 10B, respectively, are graphs showing the results of analysis of pore properties before and after heat treatment (at 1,800°C for 6 hours) of solid iron-containing carbon obtained by methane pyrolysis using nitrogen physical adsorption and mercury intrusion;

FIGS. 11A and 11B, respectively, are high-resolution transmission electron microscopy (HRTEM) images before and after heat treatment (at 2,700°C for 1 hour) of solid iron-containing carbon obtained from methane pyrolysis;

FIGS. 12A and 12B, respectively, show the results of TEM-EDS (transmission electron microscopy energy-dispersive X-ray spectroscopy) illustrating the distribution characteristics of carbon (C) and silicon (Si) in the silicon-carbon composite (Si/C) prepared by depositing silicon (Si) on the porous carbon-based material produced by heat treatment of solid iron-containing carbon obtained by methane pyrolysis; and

FIGS. 13A and 13B, respectively, show the results of HRTEM illustrating, at different resolutions, the distribution characteristics of silicon (Si) in the silicon-carbon composite (Si/C) prepared by depositing silicon (Si) onto the porous carbon-based material produced by heat treatment of solid iron-containing carbon obtained by methane pyrolysis.

## DETAILED DESCRIPTION OF THE INVENTION

Terms used herein may be defined as follows.

The term "solid carbon" or "carbon-based material" may refer to elemental carbon having an arbitrary structure in a broad sense and may be understood as a concept including various forms, such as a graphitic form, an amorphous form (e.g., carbon black and activated carbon), and the like, and may refer to graphitic carbon or a carbon-based material in a narrow sense.

The term "pyrolysis" refers to a reaction in which hydrocarbons are decomposed upon exposure to heat, for

example higher than approximately 400°C in the absence of oxygen or oxygen-containing compounds.

The term "conversion" may refer to the number of moles of the feedstock converted into a compound other than the feedstock per unit mole thereof.

The term "selectivity" may refer to the number of moles of a target product per unit mole of the converted feedstock.

The term "pitch" may refer to a distance or spacing between a screw thread and an adjacent screw thread (or a valley and an adjacent valley).

The term "angle of repose" may refer to a maximum inclination angle at which the slope face of a solid may be stabilized (i.e., the steepest angle of descent relative to the horizontal plane on which a solid granular material can be piled without slumping). The angle of repose is an inherent property of a granular material, and each granular material may have a unique angle of repose.

The term "helix angle" may refer to an angle between a tangent to the helix and an axis of the helix.

The term "crystal" or "crystalline" may typically refer to any solid-phase material in which atoms are arranged to have a lattice structure (e.g., a three-dimensional order) and may be specified by diffraction analysis (XRD), nuclear magnetic resonance analysis (NMR), differential scanning calorimetry (DSC), or a combination thereof.

The term "nanosize" may refer to, in at least one dimension, a size within the range of 1 nm to hundreds of nanometers, for example, of 200 nm or less, and for example, of 100 nm or less.

The term "graphite" refers to a material in which graphene layers are bound together by van der Waals force and the distance between adjacent graphene layers is approximately 0.335 nm.

The pore may have an appropriate wall thickness, for example, within the range of 1 to 100 nm, for example 2 to 50 nm, for example 2 to 10 nm.

The term "micropore" refers to a pore having a pore size (diameter) of less than 2 nm as defined by IUPAC.

The term "mesopore" refers to a pore having a pore size (diameter) ranging from 2 to 50 nm as defined by IUPAC.

The term "macropore" refers to a pore having a pore size (diameter) exceeding 50 nm as defined by IUPAC, for example, a pore having a pore size (diameter) within the range of 75 to 1,000 nm, and for example, 80 to 250 nm.

According to an embodiment of the present invention, first, methane in a methane-containing feedstock is converted into a hydrogen-containing gas mixture, and solid-phase carbon, for example, iron-containing carbon (or a carbon-based material) in the presence of an iron-based catalyst by pyrolysis. Then, the separated solid iron-containing carbon is heat-treated to remove iron impurities within the iron-containing carbon, to change the properties of three types of carbon pores (i.e., micropores, mesopores, and macropores) in the iron-containing carbon and to form silicon-carbon (Si/C) composite in which silicon is attached (deposited or coated) to the inside and/or outside of the pores of the porous carbon-based material. The silicon-carbon composite formed in this way is useful as electrode materials, for example, anode materials, and for example, anode materials for batteries such as lithium-ion batteries, because silicon is attached (or deposited) to the porous carbon-based material having a unique pore structure.

## Methane Pyrolysis and Formation of Solid Iron-containing Carbon

According to an embodiment, a single process is provided in a manner in which methane in a methane-containing feedstock is converted into gaseous mixture containing hydrogen and carbon monoxide, and solid iron-containing carbon (or a carbon-based material), followed by separation and recovery thereof. A process scheme according to an embodiment for illustrative purpose is as shown in FIG. 1.

With reference to the drawing, the methane-containing feedstock may be gaseous and may be introduced into a methane pyrolysis process 100 via line 1.

The methane-containing feedstock may be typically at least one selected from among pure methane, liquefied natural gas, natural gas, a mixed gas composed mainly of methane (for example, at least 50 vol%, for example at least 80 vol%, for example at least 90 vol%), and the like. In this regard, natural gas mainly contains methane, and may further comprise, in addition to methane, a hydrocarbon gas component (e.g. at least one selected from the group consisting of ethane, propane, and heavier hydrocarbons) and/or a diluent gas (e.g. at least one selected from the group consisting of nitrogen, oxygen, carbon dioxide, helium, and hydrogen sulfide). Here, the concentration of the diluent gas in the feedstock may be, for example, 15 vol% or less, for example 12 vol% or less, for example 10 vol% or less. According to a particular embodiment, the methane-containing feedstock may be pure methane.

In the illustrated embodiment, the methane-containing feedstock may be combined with an iron oxide-containing catalyst in the form of solid particles supplied via line 3, and the gaseous methane-containing feedstock and the iron oxide-containing catalyst are introduced into a reactor A via line 2. In this regard, methane, which is a stable nonpolar molecule as an inert gas, has C-H binding energy of about 435 kJ/mol, and thus has high thermodynamic stability and is not easily decomposed. The process is applicable to any methane pyrolysis reactions which can result in production of both gaseous hydrogen and solid carbon.

By way of example, to cleave the strong C-H bonds of methane molecules, pyrolysis reaction in the pyrolysis

reactor A involves or includes auto-thermal reduction in which the iron oxide-containing catalyst is reduced using methane as a reducing agent. Here, the auto-thermal reduction in the presence of an iron oxide-containing catalyst may be based on a reaction mechanism represented in Reaction Equation 1 below.

[Reaction Equation 1] $Fe_2O_3 + 3CH_4 \rightarrow 2Fe + 3CO + 6H_2$

As represented in the reaction scheme, the iron oxide-containing catalyst is converted to a reduced form (particularly, elemental iron) due to reaction with methane. In this auto-thermal reduction, unlike the steam reforming reaction of methane, carbon dioxide is not generated, carbon monoxide is formed together with hydrogen, and iron oxide is reduced to elemental iron, which may act as an active catalyst for a pyrolysis reaction to produce solid carbon (C) and hydrogen ($H_2$), as represented in Reaction Equation 2 below.

[Reaction Equation 2] $CH_4 \rightarrow C + 2H_2$

According to an embodiment, the iron oxide-containing catalyst may be at least one selected from among, for example, iron oxide, iron ore, iron-supported catalyst, and the like. In this regard, iron oxide is largely known as eight types depending on the oxidation state thereof, but in view of supply and demand, iron ore including hematite ($\alpha$-$Fe_2O_3$) or maghemite ($\gamma$-$Fe_2O_3$) with the chemical formula of $Fe_2O_3$ is favorably used. Typically, the amount of iron (Fe) (elemental basis) in iron ore may fall in the range of, for example, 60 to 70 wt%, for example 62 to 68 wt%, for example 64 to 66 wt%. Here, the amount of iron may vary depending on the origin thereof.

Also, as for the iron-supported catalyst, the support may be a porous inorganic oxide material such as alumina ($Al_2O_3$), silica ($SiO_2$), magnesia (MgO), titania ($TiO_2$), zirconia ($ZrO_2$), etc. Illustratively, the porous support may have a specific surface area (BET) of 100 to 200 $m^2/g$ (for example 130 to 180 $m^2/g$, for example 150 to 170 $m^2/g$) and a pore volume of 0.4 to 1 $cm^3/g$ (for example 0.5 to 0.9 $cm^3/g$, for example 0.6 to 0.8 $cm^3/g$). Moreover, the amount of iron (which may be in the form of elemental iron and/or iron oxide) in the iron-supported catalyst may fall in the range of, for example, 5 to 40 wt%, for example 7 to 20 wt%, for example 9 to 15 wt%.

Meanwhile, the iron oxide (e.g. $Fe_2O_3$)-containing catalyst in the form of solid particles may have an average particle size of, for example, 20 to 425 $\mu m$, for example 45 to 300 $\mu m$, for example 106 to 180 $\mu m$, when analyzed by a sieve method. Since the particle size (or size) of the iron oxide-containing catalyst may affect catalytic reaction and transfer in the reactor such as a rotary kiln reactor (when the particle size thereof is too small, injection using a supply unit or a feeder may become difficult), it may be advantageously adjusted in the above range. In this regard, when iron ore is used as a catalyst, it may be pulverized to an appropriate size (particle size). Here, pulverization may be performed using means known in the art. Examples of the pulverization means may include a roller-type grinder, a vibrating mill, a ball mill, a port mill, a hammer mill, a pulverizer, a gyratory grinder, a gyratory mill, and the like, and a combination of two or more thereof may also be used for pulverization.

Also, when the pyrolysis system is built on lab-scale, the flow rate (standard liter per minute; slm) of the methane-containing feedstock supplied to the reactor may be adjusted in the range of, for example, 0.5 to 5 slm, for example 1 to 3 slm, for example 1.5 to 2 slm. Moreover, the flow rate of the iron oxide-containing catalyst may be adjusted in the range of, for example, 15 to 80 cc/hr, for example 18 to 65 cc/hr, for example 31 to 55 cc/hr. In a commercial process, however, the absolute value of each of the flow rate of the methane-containing feedstock and the flow rate of the iron oxide-containing catalyst may increase and thus may be adjusted in consideration of the ratio between the flow rate of the feedstock and the flow rate of the catalyst. For example, based on the ratio of the flow rate of the catalyst divided by the flow rate of methane, the value may range from 0.05 to 2.6, for example from 0.1 to 1, for example from 0.2 to 0.6. However, the above numerical ranges may be understood exemplarily.

In the illustrated embodiment, the methane-containing feedstock and the iron oxide-containing catalyst in the form of solid particles are introduced into the reactor A in a co-current flow manner. The reason why the catalyst and the methane-containing feedstock are introduced in the co-current flow manner is that introduction thereof in a counter-current manner may cause production of water ($H_2O$) and consumption of hydrogen due to reaction between hydrogen generated during pyrolysis and iron oxide ($Fe_2O_3$) in the introduced catalyst.

According to an embodiment, the methane pyrolysis reactor A may be a rotary kiln-type reactor, the use of which may solve problems related to auto-thermal reduction of methane using a fluidized-bed reactor, such as increased operation difficulties due to a change in particle density and the like and difficulty in continuous operation. In particular, the rotary kiln-type reactor is less affected by the particle size of the catalyst and is easy to operate due to a large density difference between the iron oxide-containing catalyst used in the pyrolysis and the carbon produced by reaction (e.g. appearance density of iron ore: 2.24 $g/cm^3$, apparent density of carbon: 0.14 $g/cm^3$).

Also, as the pyrolysis proceeds, the carbon-based material attached to the iron-based solid particles has a high angle of repose (52°), such that volume utilization inside the reactor (e.g., a rotary kiln) increases, and accordingly the residence time of the solid increases, raising reactivity (e.g. the pyrolysis may proceed in a way that at least 10%, for

example 30 to 50% of the volume of the reactor is filled with solid, when a rotary kiln reactor is used). The angle of repose of the iron (Fe)-containing carbon-based solid produced by pyrolysis may be, for example, at least 10°, for example at least 30°, for example at least 50°.

According to an embodiment, when a rotary kiln-type reactor is used for methane pyrolysis, the residence time (τ) of the solid in the reactor is proportional to the length/diameter ratio (*L*/2r) of the kiln and the angle of repose (φ), and is inversely proportional to the inclination and rotational speed of the kiln, and may be represented by Equation 1 below.

[Equation 1]

$$\tau = \frac{L\sin(\varphi)}{2\pi r\omega\Phi}$$

Here, *L* is the length of the kiln (or tube in the rotary kiln), φ is the angle of repose, *r* is the radius of the kiln (or tube in the rotary kiln), *Φ* is the inclination of the kiln, and ω is the rotational speed.

According to an embodiment, the reaction temperature (pyrolysis temperature) in the pyrolysis reactor A may be adjusted in the range of, for example, 600 to 950°C, for example 700 to 900°C, for example 730 to 870°C, for example 750 to 850°C. Moreover, the pyrolysis may be carried out in an atmosphere of gas. The reaction pressure may be adjusted in the range of, for example, 0.1 to 10 bar, for example 0.5 to 5 bar, for example 1 to 2 bar, for example 1.3 to 1.8 bar.

Also, the residence time of the solid (for example, iron oxide-containing catalyst) in the reactor may be adjusted in the range of, for example, 1 to 150 hours, for example 10 to 120 hours, for example 15 to 100 hours.

Meanwhile, neither water ($H_2O$) nor carbon dioxide ($CO_2$) is generated in a mechanism of auto-thermal reduction reaction of methane (Reaction Equation 3 below), but carbon monoxide (or carbon dioxide and water in the initial stage of reaction) may be generated during the actual pyrolysis (in which iron oxide ($Fe_2O_3$) is reduced to a metallic form thereof while forming carbon oxides). This side reaction may be remarkable when using an inexpensive iron oxide-containing catalyst, namely iron ore. As a result, an induction section (a section until the peak conversion is reached) may be formed during the auto-thermal reduction of methane.

[Reaction Equation 3]

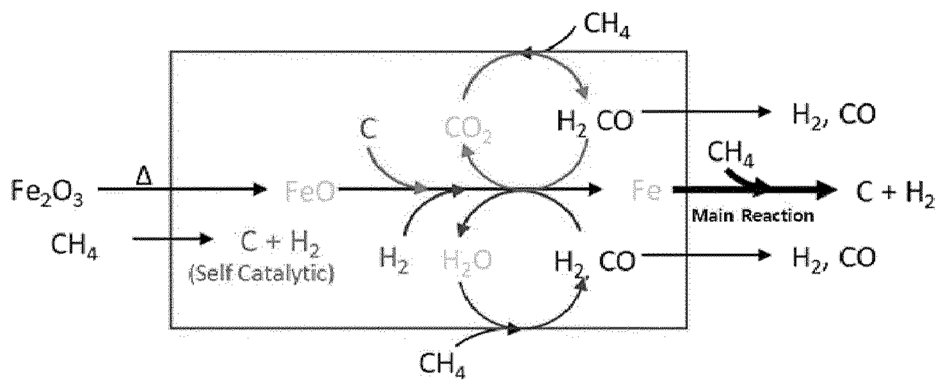


The conversion of methane in the pyrolysis reaction may be adjusted in the range of, for example, at least 70%, for example 75 to 95%, for example 80 to 90%. Here, the conversion of methane may be increased to a certain level or more by operation at an elevated reaction temperature, but the amount of hydrogen produced may be decreased due to heat loss caused by high-temperature operation, increased catalyst deactivation, etc. Hence, it may be advantageous to control the conversion of methane in consideration of the desired amounts of hydrogen and carbon produced and the amount of hydrogen produced per active metal in the catalyst.

Also, respective selectivity vales of hydrogen and carbon monoxide in the gas products (e.g. based on a conversion of methane of 90%) may be, for example, at least 1% (for example at least 1.5%, for example at least 2%), and at least 1% (for example at least 1.5%, for example 2 to 5%). However, it is to be understood that the above numerical ranges are described for illustrative purposes.

Referring to FIG. 1 again, as ferric oxide ($Fe_2O_3$) in the catalyst is reduced by methane in the reactor A, a gas mixture containing unreacted methane as well as hydrogen and carbon monoxide, and solid carbon may be produced. Here, the solid carbon may be graphitic carbon. Graphite has a layered structure, where plate-shaped two-dimensional graphene, in which carbon atoms are linked in a hexagonal shape, is stacked. The graphitic carbon produced in the

present embodiment may be composed of, for example, 15 to 30 layers of graphene, for example 18 to 25 layers of graphene. In this regard, as the iron content in the iron-based catalyst introduced into the reactor A increases, carbon having a graphite-type structure can be easily formed. The content of graphitic carbon in the produced carbon may be, for example, at least 90% by weight, for example at least 95% by weight, and for example at least 99% by weight, and may be substantially composed of graphitic carbon. The carbon thus produced may be combined with catalyst particles to form an iron (Fe)-containing carbon-based solid (C/Fe).

Without willing to be bound by a specific theory, the mechanism by which graphitic carbon is formed can probably be explained as follows: first, methane on the surface of iron (Fe) reduced by an autothermal reduction reaction is converted into amorphous carbon and hydrogen, and then $Fe_3C$ is produced on the surface of iron (Fe) by diffusion of amorphous carbon. Methane may be further converted into amorphous carbon and hydrogen through the catalytic action of $Fe_3C$ thus formed. As such, the internal Fe is crystallized into $Fe_3C$ through continuous diffusion of amorphous carbon and at this time, the supersaturated carbon may be converted into graphite-type carbon.

In this regard, the ratio $I_D/I_G$ for solid iron-containing carbon upon Raman spectroscopy is at least 1.1, for example, within the range of 1.2 to 1.8, for example within the range of 1.3 to 1.7. Here, $I_D/I_G$ refers to a ratio of the D band to the G band measured by Raman spectroscopy and is used as the ratio of disorder/graphitic carbon. A carbon material having a ratio of 0 may mean single layer graphene.

According to an embodiment, as the carbon produced by pyrolysis is attached to the catalyst particles, a solid may be formed in a weight that is increased by at least 3 times, for example, 4 to 10 times, and 5 to 9 times than the content of iron, which is an active metal in the iron-based catalyst introduced at the beginning of the reaction. In addition, as described above, as reaction progresses inside the reactor, the amount of carbon attached to the catalyst particles also increases and thus an angle of repose may increase compared to the iron-based particles at the beginning of the reaction.

As an example, the apparent density of the iron oxide-containing catalyst in the form of solid particles introduced into the reactor A may be, for example, 0.8 to 2.8 $g/cm^3$, for example 1 to 2.5 $g/cm^3$, for example 1.5 to 2.25 $g/cm^3$, while the apparent density of the iron (Fe)-containing carbon-based solid discharged from the reactor A may be, for example, 0.05 to 0.5 $g/cm^3$, for example 0.1 to 0.25 $g/cm^3$, for example 0.12 to 0.2 $g/cm^3$.

The reason why unreacted methane is contained in the gas products in the present embodiment is due to a thermodynamic equilibrium of methane, hydrogen, carbon monoxide, and carbon during the pyrolysis with an increase in the internal temperature of the reactor and thus the conversion of methane does not rise any more.

According to an embodiment, the configuration of the rotary kiln reactor applicable to the reaction involving methane auto-thermal reduction is schematically shown in FIG. 2.

With reference to the drawing, as described above, the gaseous methane-containing feedstock is introduced into a rotary kiln reactor 200 via line 201, after which an iron oxide-containing catalyst is supplied in a controlled amount by valve operation from a catalyst storage device (e.g. a hopper 202), combined with the methane-containing feedstock, and then introduced together into a tube 204 in the rotary kiln reactor. The tube 204 provides a space for pyrolysis (involving auto-thermal reduction of methane) to occur while accommodating solid particles (i.e. iron oxide-containing catalyst) and gas (i.e. methane-containing feedstock). Moreover, the material of the tube 204 may be at least one selected from among, for example, alumina, SiC, FeCrAl alloy, Inconel (NiCr), heat-resistant stainless steel, and the like. Further, any refractory material or bricks may be deposited on the internal surface of the tube 204.

In the illustrated embodiment, the tube 204 is configured such that buffer tubes (e.g., an inlet buffer tube 204' and an outlet buffer tube 204") are connected or linked to both sides of a central work tube. Here, the work tube may indicate an area of the tube in which pyrolysis occurs by receiving heat necessary for the reaction in the inner space of the tube 204. As an example, a heater 205 may be provided outside the tube along the length of the work tube. Hereinafter, for consistency of description, "tube" refers to the work tube in which the reaction takes place.

According to an embodiment, the ratio of the length to the inner diameter of the tube 204 (L/D) may be determined in consideration of the residence time of the iron-based catalyst, and may be set in the range of, for example, 5 to 50, for example 10 to 30, for example 15 to 20, which is understood exemplarily.

As the heater 205, any heater known in the art may be used, so long as it is able to supply heat sufficient for pyrolysis into the work tube, specifically formation of free methyl radicals as an activated form of methane and reduction of iron oxide in the catalyst. This heater may be provided outside and/or inside the tube 204. Examples of the heater 205 may include a heat exchanger, a heating coil, and a combustion heater, which may be used alone or in combination. In the illustrated example, the heater 205 may be provided in a way to surround at least a portion of the outside of the tube 204, whereby heat may be transferred to the inner space through the wall of the tube. Also, a housing 206 is configured to surround at least the work tube, making it possible to minimize external influence on the reaction conditions in the tube in which pyrolysis occurs.

In order to rotate the tube 204 in the rotary kiln reactor 200, a rotator 206, for example, a motor may be provided at any position. In FIG. 2, an inlet for the methane-containing feedstock and the solid particle catalyst may be provided at one end of the tube 204, and a motor 206 may be provided at the remaining end (opposite end). Moreover, rotational force may be supplied to the tube 204 via a power transmission member mechanically connected or engaged with the motor, for

example, a gear, belt, chain, or the like. Illustratively, it may be advantageous to consider the effect of the supply rate of the solid catalyst particles on the rotational speed of the tube 204 during pyrolysis (the methane conversion may decrease with a decrease in the supply rate of the solid catalyst particles, while transfer of the solid catalyst particles may become difficult with a decrease in the rotational speed of the tube 204).

Considering this tendency, the rotational speed of the tube 204 may be adjusted within a range that is able to increase the average hydrogen production, for example, 0.05 to 5 rpm, for example 0.1 to 3 rpm, for example 0.12 to 2 rpm, for example 0.2 to 1 rpm.

According to an exemplary embodiment, due to co-current transfer of the solid iron oxide-containing catalyst particles and the methane-containing feedstock (gas), a pretreatment section and a reaction section may be separately provided in the tube 204. In the pretreatment section, the catalyst particles may be activated using methane, and the extent of activation may vary depending on the temperature. For example, when iron oxide-containing catalyst particles are activated at a relatively low temperature (which may be adjusted in the range of 600 to 800°C, for example 700 to 780°C, for example 725 to 750°C), the amount (weight) of carbon produced per weight of iron that is an active metal may increase. As an example, in the pretreatment process, methane and catalyst particles may be introduced in a co-current manner into the tube 204, and the auto-thermal reduction route may be promoted under temperature conditions adjusted as described above, whereby the iron oxide-containing catalyst may be activated to form carbon monoxide and metallic Fe.

Meanwhile, the kiln of the rotary kiln reactor 200 can be operated at the horizontal position (i.e., slope of 0°). According to an alternative embodiment, the rotary kiln reactor may be inclined at a predetermined angle in the direction of movement of the solid particles in order to control the residence time of the solid particles. Here, the inclination angle (slope) may be adjusted in the range of 0.01 to 10°, for example 0.02 to 5°, for example 0.05 to 2° on a horizontal basis. The inclination angle may be properly adjusted within the above range in consideration of the fact that the residence time of the solid catalyst particles decreases with an increase in the inclination of the kiln.

In the illustrated embodiment, gas and solid products produced by pyrolysis (involving auto-thermal reduction of methane) in the tube 204 of the rotary kiln reactor are discharged from the tube 204, and as mentioned in conjunction with FIG. 1, the gas mixture and the solid are separated from each other using a gas-solid separator 207. Here, the separated gas mixture may be recycled through line 203 and combined with fresh feedstock. Meanwhile, the separated solids, that is, the solid iron-containing carbon, may be collected by a solid collector 208 and impurities such as iron may be removed in the subsequent heat treatment as described later and carbon may have particular pore properties.

According to an embodiment, the efficiency of pyrolysis may be improved by introducing a screw and lifter combination into a tube of a rotary kiln-type reactor.

In this regard, a kiln equipped with screw baffles is regarded as different from conventional screw-type reactors. By way of example, the screw-type reactors are generally known as auger-type reactors, in which a screw shaft is inserted into a tube. The screw-type reactors are applied to transfer of solid with no change in volume (e.g. polymers, etc.), like extruders, and a screw structure formed on a rotating shaft provided at the center of the tube allows the solid in the tube to move forward by action of a helix flight formed on the shaft according to the rotation of the shaft. However, when carbon generated by pyrolysis of methane occupies much larger volume than the initially introduced catalyst particles as in the present embodiment, uniform contact between the gaseous reactant and the catalyst particles may be prevented and it may be difficult to carry out the reaction at a desired reaction temperature. In particular, as described above, it is preferable to fill the tube of the rotary kiln with a large volume of solid by the increased angle of repose, but when a screw shaft is present, it may be difficult to increase or control the residence time with an increase in the angle of repose. Further, the screw-type reactors are very suitable for reaction during which the volume of solid decreases (for example, a reaction in which biomass is gradually pyrolyzed), but are not suitable for methane pyrolysis in which the volume of solid increases due to the generation of carbon during the reaction.

Taking into consideration the foregoing, in the present embodiment, unlike the conventional screw-type reactors, a helix baffle is formed to extend along the inner circumferential surface of the tube so that solid particles (or solid) introduced into the tube are transferred. Therefore, the helix baffle formed on the inner circumferential surface of the tube rotates according to rotation of the tube, instead of having a screw shaft, induces forward movement of the solid.

In this regard, FIG. 3 is a side view, a plan view, and a front view showing a combination of a helix baffle and lifters in the tube of the rotary kiln reactor usable in the present embodiment.

In the illustrated embodiment, the height $h_1$ of the helix baffle may affect the size of the moving space of the solid in the center of the tube (i.e. the cavity size inside the tube), and may be adjusted in the range of, for example, 1/10 to 1/2, for example 3/20 to 8/20, for example 1/5 to 3/10 of the inner diameter (diameter) of the tube. Also, the pitch P of the helix baffle may be adjusted in the range of, for example, 1/60 to 1/6, for example 1/30 to 2/15, for example 1/20 to 1/10 of the tube length. However, these dimensional ranges may be understood for illustrative purpose only, and thus may be changed in a scale-up process.

Further, the helix baffle essentially has a helix angle, and this helix angle may be determined depending upon the residence time of the solid catalyst. As an example, the helix angle of the helix baffle may be adjusted in the range of, for example, 30 to 60°, for example 35 to 55°, for example 40 to 50°.

With reference to the drawing, at least one lifter is provided on the inner circumferential surface of the tube corresponding to at least one among pitches P of the helix baffle formed in the tube. Typically, lifters may be provided at respective pitches of the helix baffle in the tube, but in some cases, no lifters may be provided in areas corresponding to some pitches, or lifters having other shapes may be provided.

In the illustrated embodiment, one lifter is provided per pitch of the helix baffle, and is formed at an angle of 90° with respect to the lifter provided at an adjacent pitch when viewed from the front (lifters 1 to 4 in FIG. 3). This arrangement may be understood for illustrative purpose only, and in the present embodiment, the angle between the lifters may be properly adjusted in the range of, for example, 30 to 360°, for example 50 to 180°, for example 60 to 120°.

In the illustrated embodiment, the height $h_2$ of the lifter may be determined in consideration of the height $h_1$ of the helix baffle, and may be adjusted in the range of, for example, 1/10 to 1/2, for example 3/20 to 8/20, for example 1/5 to 3/10 of the inner diameter (diameter) of the tube. Furthermore, the thickness of the lifter may fall in the range of, for example, 1/20 to 1/2, for example 1/10 to 2/5, for example 3/20 to 3/10 of the height $h_2$ of the lifter. In addition, according to an embodiment, the ratio of the height $h_2$ of the lifter to the height $h_1$ of the helix baffle may be adjusted in the range of, for example, 0.25 to 2, for example 0.5 to 1.5, for example 0.75 to 1.25.

In this regard, as the catalyst particles move within the tube of the rotary kiln reactor, the catalyst particles are divided by the lifters as schematically shown in FIG. 4.

With reference to the drawing, when the catalyst particles move along a helical surface in the rotating tube and contact (or collide) with the lifters, they move while being divided into spaces in front of and behind the pitch where each lifter is provided (i.e. residence time of the catalyst particles may be increased because the catalyst particles are dispersed during movement in the tube). In this way, by combining the lifters and the helix baffle formed on the inner circumferential surface of the tube in the rotary kiln reactor, the residence time of the solid, particularly the solid particle catalyst, in the reactor may be controlled. As such, the combination of the helix baffle and the lifters enables uniform contact between the gaseous methane-containing feedstock and the catalyst over a controlled period of time, thereby maximizing production of target products, such as hydrogen, carbon monoxide, and carbon. Moreover, the amount of the solid catalyst particles that move forward may be adjusted simply by changing the internal structure and dimensions of the tube, such as the number, shape, dimensions, and arrangement of lifters and the height and pitch of the helix baffle.

A modification in which a plurality of lifters (particularly, four lifters) per pitch of the helix baffle is provided at a predetermined angle to each other is shown in FIG. 5.

With reference to the drawing, a plurality of lifters is provided per pitch, and in the illustrated embodiment, four lifters are provided per pitch, which may be understood for illustrative purpose only. As an example, lifters of up to 12, for example 2 to 10, for example 3 to 6 may be provided per pitch. As other details have been described with regard to FIG. 3, a redundant description thereof will be omitted.

When the helix baffle and the lifters are combined in this way, disadvantages when separately installing the helix baffle and the lifters may be effectively alleviated (when installing only the helix baffle, it may be advantageous to transfer the solid catalyst particles in the rotary kiln, but efficient contact between the catalyst and the gaseous feedstock may be difficult, and when installing only the lifters, contact between the catalyst and the gaseous feedstock may be improved, but it may be difficult to transfer the catalyst at a constant amount or speed).

Various examples of the shapes of the lifters provided in the tube of the rotary kiln reactor are shown in FIGs. 6A to 6C.

Specifically, FIG. 6A shows a straight lifter, and FIGs. 6B and 6C show bent lifters. In FIG. 6B, since the lifter has a shape bent in an oblique line, the function of increasing the lifting amount (volume) of the catalyst and the lifting height of the catalyst may be enhanced due to the increased volume of the lifter. Also, in FIG. 6C, the lifter has a shape bent at an angle of 90° (or a rectangular lifter), and as such, an increase in the lifting height of the catalyst is more remarkable.

Meanwhile, in accordance with the process shown in FIG. 1, the gas-phase mixture and the solid-phase iron-containing carbon (C/Fe) formed by methane pyrolysis in the reactor A pass through the line 4 and are then separated by a gas-solid separator B known in the art. Examples of such a separator include a cyclone, a hydrocyclone, a gravity settling device, a spray scrubber, a venturi scrubber, a bag filter, a pocket filter, an electrostatic precipitator, and the like. Based on the gas-solid separation described above, the gas mixture containing hydrogen, carbon monoxide, and methane may be transferred through line 5.

According to an embodiment, the molar ratio of hydrogen ($H_2$)/carbon monoxide (CO) in the gas mixture (e.g. based on a methane conversion of 50 to 90%) may be adjusted in the range of, for example, 20 to 70, for example 40 to 65, for example 50 to 60, and may be 55 in a specific embodiment.

Also, the molar ratio of hydrogen ($H_2$)/methane ($CH_4$) in the gas mixture (e.g. based on a methane conversion of 50 to 90%) may be adjusted in the range of, for example, 1 to 60, for example 3 to 55, for example 10 to 50. Specifically, based on the methane conversion of 90%, the molar ratio thereof may be adjusted in the range of 15 to 60, for example 20 to 40, for example 23 to 30. Based on the methane conversion of 70%, the molar ratio thereof may be adjusted in the range of 3 to 10, for example 4 to 8, for example 5 to 6. Based on the methane conversion of 50%, the molar ratio thereof may be adjusted in the range of 1 to 4, for example 1.5 to 3, for example 2 to 3. In a specific embodiment, the molar ratio of hydrogen

($H_2$)/methane ($CH_4$) in the gas mixture may be 26.

For the iron (Fe)-containing carbon-based solid, the molar ratio of carbon (C)/iron (Fe) (e.g. based on a methane conversion of 50 to 90%) may be adjusted in the range of, for example, 25 to 60, for example 30 to 50, for example 35 to 45, and may be 42 in a specific embodiment.

As described above, the gas mixture separated using the gas-solid separator B may be transferred to a process gas compressor C and pressurized. Here, the reason why pressurization is performed is due to a downstream adsorption process. As an example, the increased pressure may be determined considering a difference in adsorption capacity depending on the pressure of the adsorbent. For example, in a 4-tower pressure swing adsorption (PSA) process, the adsorption pressure to achieve a hydrogen recovery of 85 to 90% may fall in the range of at least 10 bar, for example 12 to 25 bar, for example 15 to 20 bar.

With reference to FIG. 1, the pressurized gas mixture may be separated into hydrogen, carbon monoxide, and methane via line 6 using a gas separation technique known in the art. Examples of the gas separation technique may include pressure swing adsorption (PSA), vacuum swing adsorption (VSA), membrane separation, and the like. In the illustrated embodiment, the pressurized gas mixture may be transferred to a PSA unit D, in which the PSA unit may be filled or packed with an adsorbent corresponding to the type of gas to be separated. Here, PSA, as is known in the art, may be a technique for separating gases using adsorption capacity varying depending on a difference in pressure and adsorption characteristics of solid adsorbents to gaseous materials.

In this regard, the PSA unit may be typically filled with an adsorbent corresponding to the molecular size and adsorption strength of the gas component. Here, the pore size of the adsorbent capable of selectively adsorbing each of carbon monoxide and methane may fall in the range of 4 to 5 Å. However, hydrogen with the lowest adsorption strength may be separated in such a manner that it is discharged without being adsorbed.

Typically, (i) molecular sieves (e.g. 4A zeolite, 5A zeolite) for nitrogen, carbon monoxide, and methane, (ii) activated carbon for methane, C2 and C3 hydrocarbons, and carbon dioxide, (iii) silica gel for C3 or higher hydrocarbons, and (iv) activated alumina for aromatics, $H_2S$, $H_2O$, HCl, etc., may be used (adsorption strength increases in the order from (i) to (iv)). However, in the present embodiment, since the gas mixture generated by pyrolysis mainly contains hydrogen, carbon monoxide, and methane, three gas components may be separated from each other only using a molecular sieve and activated carbon. Briefly, hydrogen, carbon monoxide, and methane are produced as pyrolysis products, and thus the number of adsorbents required for gas separation may be decreased.

The types of adsorbents and principles of adsorption and desorption for separating hydrogen, carbon monoxide, and methane are known in the art, and a description thereof will be omitted. According to an embodiment, however, desorption operation conditions may be set depending on target recovery of hydrogen, carbon monoxide, and methane. In this regard, the recovery may increase with a decrease in desorption pressure, and the purity of the separated gas may decrease with an increase in the recovery. Considering this correlation, the desorption operation pressure to achieve a hydrogen recovery rate of 85 to 90% may be set to 1 to 1.5 bar.

As described above, through the gas mixture separation process, methane, hydrogen, and carbon monoxide are discharged through respective lines 7, 8 and 9. As such, hydrogen and carbon monoxide may be recovered as target products. On the other hand, methane may be recycled through a splitter E and may be combined with a fresh methane-containing feedstock via line 10.

Meanwhile, referring to FIG. 1, the iron-containing carbon may be separated and recovered through line 11 and may be subjected to heat treatment as described later. According to an embodiment, the recovered iron-containing carbon may have all three types of pore structures of micropores, mesopores, and macropores.

This pore structure may be affected by reaction conditions such as the pyrolysis temperature of methane. For example, when the pyrolysis temperature is low, the pore volume of micropores and mesopores and specific surface area (BET), and the content of iron in the solid (iron-containing carbon) are relatively high, while when the pyrolysis temperature is high, the pore volume of micropores and mesopores and specific surface area (BET), and the content of iron in the solid are relatively low. In this regard, the content of iron in the iron-containing carbon may be, for example, within the range of 0.1 to 20% by weight, for example, 0.5 to 15% by weight, and for example 1 to 10% by weight. In addition, the specific surface area (BET) of the iron-containing carbon may be determined, for example, within the range of 10 to 50 $m^2/g$, for example 20 to 40 $m^2/g$, and for example 25 to 35 $m^2/g$.

According to an embodiment, the pore volume of micropores and mesopores in the iron-containing carbon may be, for example, within the range of 0.05 to 0.2 $cm^3/g$, for example 0.07 to 0.15 $cm^3/g$, for example 0.08 to 0.1 $cm^3/g$. In addition, the size of micropores and mesopores in the iron-containing carbon measured by nitrogen adsorption (physical adsorption) may be, for example, within the range of 1.5 to 50 nm, for example 1.6 to 10 nm, for example 1.8 nm to 5 nm.

In a certain embodiment, micropores and mesopores of the iron-containing carbon may be classified into primary pores and secondary pores depending on the pore size (diameter) range. Here, the size of the primary pores may be, for example, within the range of 1.5 to 4 nm, for example 2 to 3 nm, and for example 2.3 to 2.7 nm, and the size of the secondary pores may be, for example, within the range of 4 to 50 nm, for example, 4.2 to 10 nm, and for example 4.5 to 6 nm.

In addition, the size of the macropores in the iron-containing carbon, measured by mercury intrusion according to

ASTM D4284 or ISO 15901-1, may be within the range, for example, of 50 to 200 nm, for example of 75 to 150 nm, and for example of 90 to 140 nm. In addition, the pore volume of the macropore, measured by mercury intrusion according to ASTM D4284 or ISO 15901-1, may be, for example, at least 0.1 $cm^3/g$, for example 0.2 to 1 $cm^3/g$, for example, 0.3 to 0.8 $cm^3/g$, for example 0.35 to 0.6 $cm^3/g$.

Heat treatment

According to an embodiment, heat treatment is performed to change the pore structures (for example, micropores, mesopores, and macropores) of carbon while removing impurities such as an iron component from the solid iron-containing carbon and thereby to form a porous carbon-based material having pore properties suitable for electrode materials.

As described above, the carbon produced by methane pyrolysis may have a graphitic carbon (graphite) structure and may also include all three pore structure types, namely, micropores, mesopores, and macropores. At this time, iron impurities, and the like are removed by vaporization or evaporation through heat treatment, while the volumes of micropores and mesopores increase.

According to an embodiment, the heat treatment may be performed under conditions in which iron impurities are effectively removed from the iron-containing carbon by vaporization or evaporation and an oxidation reaction cannot occur. In this regard, the heat treatment temperature may be, for example, at least 1,600°C, for example, within the range of 1,700 to 2,900°C, and for example, within the range of 1,800 to 2,700°C. In addition, the heat treatment pressure may be adjusted in consideration of the design pressure of a heat treatment furnace, or the like, for example, 1 atm or less, for example 0.9 atm or less, and for example 0.5 to 0.8 atm. Heat treatment under the pressure conditions described above may be advantageous in terms of impurity treatment speed and economic efficiency, but this is provided as an example.

In addition, the heat treatment may be performed in an inert gas atmosphere and inert gas may, for example, include at least one gas selected from nitrogen, helium, argon, neon and the like.

According to an embodiment, the heat treatment time may be, for example, at least 2 hours, for example at least 2.5 hours, for example at least 3 hours, and in other embodiments, the heat treatment time may be controlled within the range of 3 to 12 hours, for example 4 to 10 hours, for example 5 to 8 hours, for example 6 to 7 hours. Meanwhile, according to an alternative embodiment, the heat treatment time may be varied depending on the heat treatment temperature and may be, for example, controlled within the range of 0.5 to 12 hours, for example 1 to 8 hours, for example 2 to 6 hours.

The heat treatment time may be adjusted in consideration of the amount of impurities in the iron-containing carbon to be subject to heat treatment. When the heat treatment time is excessively short or long, impurities may remain. Therefore, the heat treatment time is preferably adjusted within the range, but this is provided as an example.

According to an embodiment, as heat treatment progresses, iron impurities are removed by vaporization or evaporation from the iron-containing carbon and other impurities (when iron ore or decorated iron catalysts are used, they may contain other impurities such as silicon and aluminum) may also be removed therefrom. Such heat treatment causes formation of porous carbon with increased purity and the content of iron (on an elemental basis) in the porous carbon is, for example, 20 mg/kg or less, for example 10 mg/kg or less, and for example 5 mg/kg or less. In addition, impurities other than iron impurities may also be present in an amount of 1 mg/kg or less, for example 0.1 mg/kg or less, and for example may be substantially absent.

According to an embodiment, the pore structure in the carbon may be changed through the heat treatment described above. In particular, it should be noted that the pore volume of micropores and mesopores and the size of macropore, respectively, increase. In this regard, the pore volume of micropores and mesopores in the porous carbon-based material formed by heat treatment may be, for example, controlled within the range of at least 5% (for example 5 to 20% and for example 7 to 10%) of the total pore volume of the porous carbon-based material.

According to an embodiment, the pore volume of micropores and mesopores in the heat-treated porous carbon-based material is, for example, 0.08 to 0.25 $cm^3/g$, for example 0.09 to 0.2 $cm^3/g$, for example 0.1 to 0.15 $cm^3/g$.

The pore volume of micropores and mesopores in the heat-treated porous carbon-based material is, for example, at least 5%, for example 10 to 20%, for example 13 to 18% more higher than the pore volume of micropores and mesopores before heat treatment (i.e., iron-containing carbon). In certain embodiments, such a pore volume may be 15% higher than the pore volume of micropores and mesopores before heat treatment.

According to an embodiment, the size of micropores and mesopores in the porous carbon-based material produced through heat treatment, as measured by nitrogen adsorption, is, for example, within the range of 1.5 to 50 nm, for example 1.6 to 10 nm, for example, 1.8 to 5 nm. According to certain embodiments, the sizes of micropores and mesopores may be similar to those before heat treatment.

In addition, similar to iron-containing carbon before heat treatment, the porous carbon-based material after heat treatment may include primary pores and secondary pores depending on the pore size, as measured by nitrogen adsorption. Here, the size of the primary pore may be, for example, within the range of 1.5 to 3.5 nm, for example 2 to 3 nm, and for example 2.3 to 2.7 nm, and the size of the secondary pore may be, for example, within the range of 3.5 to 50 nm, for

example 3.8 to 7 nm, and for example 4 to 5 nm.

Meanwhile, the size of the macropores in the porous carbon-based material, when measured by mercury intrusion according to ASTM D4284 or ISO 15901-1, are increased by about 5 to about 20%, for example 6 to 18%, for example 7 to 15% than the size of the macropores in the carbon-based material (iron-containing carbon) before heat treatment. In addition, the pore volume of the macropores, preferably macropores having a pore size from 65 to 250 nm, for example from 70 to 200 nm, and for example from 90 to 170 nm, in the porous carbon, measured by mercury intrusion according to ASTM D4284 or ISO 15901-1, may be, for example, at least 0.1 $cm^3/g$, for example 0.2 to 1 $cm^3/g$, and for example 0.3 to 0.8 $cm^3/g$, for example 0.35 to 0.6 $cm^3/g$. In certain embodiments, the pore volume of the macropores in the porous carbon may be similar to that before heat treatment.

In addition, the specific surface area (BET) of porous carbon formed through heat treatment may be affected by the methane pyrolysis conditions (for example, methane pyrolysis temperature) before heat treatment. As previously described, carbon (i.e., iron-containing carbon) formed by methane pyrolysis at a relatively low temperature has higher specific surface area than carbon (i.e., iron-containing carbon) formed at a higher temperature by methane pyrolysis. However, porous carbon obtained by heat treatment of the lowtemperature methane pyrolysis product may have a lower specific surface area than porous carbon obtained by heat treatment of a high-temperature methane pyrolysis product. For example, the specific surface area of the porous carbon formed by heat treatment is, for example, in the range of 8 to 45 $cm^2/g$, for example, 12 to 40 $cm^2/g$, and for example 15 to 35 $cm^2/g$.

Meanwhile, the amorphous carbon may be reduced by heat treatment. The ratio $I_D/I_G$ of porous carbon upon Raman spectroscopy may be within the range of, for example 1 or less, for example 0.7 or less, for example 0.4 to 0.65.

In embodiments, the ratio $I_D/I_G$ of the porous carbon-based material is, for example, at least 40%, for example 45 to 80%, for example 50% to 65% lower than that of the iron-containing carbon before heat treatment. In addition, the results of XRD analysis show that the crystallinity of carbon is maintained before and after heat treatment. For example, carbon before heat treatment has an interplanar distance in the d(002) direction of 3.37 A, while carbon after heat treatment has an interplanar distance in the d(002) direction of at least 3.38 A, for example within the range of 3.38 to 3.40 A.

Therefore, the decrease in the ratio $I_D/I_G$ upon Raman spectroscopy and the similarity of the interplanar distance in the d(002) direction during XRD analysis indicate that amorphous carbon is converted into crystalline carbon, rather than the crystallinity of crystalline carbon being increased by heat treatment.

Preparation of silicon-carbon (Si/C) composite

According to an embodiment, silicon may be attached to or combined with a porous carbon-based material formed through heat treatment to prepare a silicon-carbon (Si/C) composite.

In this regard, the silicon-carbon composite may be prepared using a method known in the art, typically using a vapor deposition method, for example, chemical vapor deposition (CVD) or physical vapor deposition (PVD).

According to an embodiment, silicon may be attached (deposited) to the porous carbon-based material by CVD. In this case, the source of silicon may be a gaseous siliconcontaining compound, for example, at least one selected from silane ($SiH_4$), disilane ($Si_2H_6$), dichlorosilane ($SiCl_2H_2$), and methyl trichlorosilane, and for example silane ($SiH_4$). In addition, this gaseous silicon source may be used in combination with hydrogen and/or an inert gas, and the inert gas may be, for example, selected from nitrogen, helium, argon, neon, and the like. According to certain embodiments, a mixture of silane and nitrogen may be used as the silicon source. In this regard, the concentration (by volume) of the silicon source in the mixture of the gaseous silicon source and other gases (hydrogen and/or inert gases) may be within the range of, for example, up to 100%, for example, 1 to 90%, for example, 20 to 80%, for example, 30 to 50%, but this is provided as an example.

According to an embodiment, the deposition temperature of silicon may be adjusted in consideration of the decomposition temperature of the silicon source and may be determined, for example, within the range of 300 to 1,000°C, for example 400 to 800°C, for example 450 to 700°C. For example, when silane is used as a silicon source, silane may be decomposed into silicon and hydrogen under the elevated temperature conditions described above. In addition, the pressure within the reactor during silicon deposition may be determined in consideration of the deposition rate, flow rate of the silicon source, residence time of carbon, and the like and may be controlled within the range of, for example, 0.5 to 2 atm, for example 0.75 to 1.5 atm, for example 0.8 to 1.2 atm.

According to an embodiment, the silicon source (or a mixture of a gaseous silicon source and other gas) is fed into a reactor (or reaction vessel) with an inlet and an outlet. In addition, a porous carbon-based material may be placed in the reactor prior to feeding of the gas or gas mixture. As a result, the gaseous silicon source (or silicon source-containing mixed gas) fed into the reactor decomposes while flowing over the carbon-based material and/or passing through the interior of the carbon-based material, so that silicon can be attached to and/or coated on the outer surface of the carbon-based material. For example, the volume of the gaseous silicon source fed per gram of carbon in the reactor may be adjusted, for example, within the range of 1 to 5 L, for example 2 to 4.5 L, and for example 2.2 to 4 L.

The type of reactor applicable to silicon deposition according to the embodiment may typically be a rotary kiln-type reactor. Various other types of reactors, such as fluidized bed reactors and fixed bed reactors, may also be used. However, the rotary kiln-type reactor may be advantageous in that gas phase reactants form solid phase products.

Through the above-described attachment or deposition process, silicon is attached to the porous carbon-based material to form a silicon-carbon (Si/C) composite. According to an embodiment, the silicon in the silicon-carbon (Si/C) composite may be attached with a thickness adjusted within the range of, for example, 10 to 200 nm, for example 30 to 100 nm, and for example 40 to 70 nm. In addition, the content of silicon in the silicon-carbon (Si/C) composite may be determined, for example, within the range of 10 to 70% by weight, for example 30 to 60% by weight, and for example 40 to 55% by weight. In this regard, taking into consideration the fact that the content of silicon in the composite may affect the anode capacity when applied to anode materials for batteries, it would be advantageous to appropriately adjust the content of silicon within the above-mentioned range, but this is provided as an example.

According to an embodiment, the content of the silicon-carbon composite in the electrode material may be adjusted in consideration of the anode capacity and may be, for example, within the range of at least 40% by weight, for example at least 50% by weight, for example 60 to 90% by weight, but this is provided as an example.

Meanwhile, according to an embodiment, when the silicon-carbon composite is applied as anode material, the charging capacity and discharging capacity are, for example, at least 2,100 mAh/g (for example 2,110 to 2,120 mAh/g, for example 2,114 to 2,116 mAh/g), and at least 1,800 mAh/g (for example, 1,810 to 1,820 mAh/g, for example 1,811 to 1,813 mAh/g), respectively. In addition, the initial coulombic efficiency may be, for example, at least 85%, for example at least 85.5%, and for example at least 85.7%.

A better understanding of the present invention may be obtained through the following examples.

## Examples

The properties of the materials in Examples and Comparative Examples were analyzed as follows.

- The pore volume and pore size of the macropores were measured by mercury intrusion using a mercury titrator (MicroActive AutoPore V 9600® from Micromeritics). This equipment, which complies with the requirements of ASTM D4284 and ISO 15901-1, was utilized to determine both the porosity and macropore size. During the measurement, the pressure ranged from 0.2 to 60,000 psi.
- The specific surface area was measured by physical nitrogen adsorption ($N_2$ adsorption) using a physical adsorption analyzer (3D Flex® from Micromeritics).
- The size and pore volume of micropores and mesopores were measured using physical nitrogen desorption ($N_2$ desorption) using a physical adsorption analyzer (3D Flex® from Micromeritics).

- The ratio $I_D/I_G$ upon Raman spectroscopy was measured using a Raman spectrometer (InVia® from Renishaw).
- XRD pattern, Lc and d(002) were measured using an X-ray diffractometer (X'pert PRO® from PANalytical).
- TGA (thermogravimetric analysis) was performed using TGA/DSC 1 from Mettler Toledo.
- The distribution of elements in the product was analyzed through transmission electron microscopy energy-dispersive X-ray spectroscopy (TEM-EDX); Tecnai F30® from FEI).
- The content of element in the product was measured using ICP (inductively coupled plasma) spectroscopy (700s from Agilent).

In this example, iron ore (apparent density: 2.24 g/cm$^3$; average particle size: 106 to 180 $\mu$m) particles were used as the catalyst and high purity methane (99.97%) was used as the methane-containing gas.

Meanwhile, batch and continuous methane pyrolysis reactions were performed using a horizontal tube reactor and a rotary kiln-type reactor, respectively.

The material of the tube in the horizontal tube reactor during the batch methane pyrolysis reaction was quartz, a quartz boat capable of containing the catalyst was placed in the inner center of the tube, and the reaction gas was designed to flow in the tube in one direction.

Meanwhile, methane pyrolysis was performed in the rotary kiln-type reactor using equipment produced by the present inventor shown in FIG. 2. The material of the tube in the rotary kiln-type reactor was Inconel 601 and a heater made of FeCrAl alloy (Kanthal A1) was installed on the outer surface of the tube to provide heat necessary for pyrolysis. Each of the spiral baffle and lifter formed on the tubes in the rotary kiln-type reactor was made of Inconel 601. In addition, a catalyst storage device, a feeder connected to the catalyst storage device, a discharge buffer tube, and a carbon storage device connected to the discharge buffer tube are provided, and the catalyst storage device and the carbon storage device were designed not to be affected by the internal pressure of the reactor for continuous operation.

### A. Methane pyrolysis 1

The methane pyrolysis conditions performed in the horizontal tube reactor were set as shown in Table 1 below.

[Table 1]

| Classification | Pyrolysis conditions |
|---|---|
| Reaction temperature | 800°C |
| Reaction pressure | 1.0 bar |
| Flow rate of methane in gaseous feedstock | 0.1 slm |
| Amount of catalyst | 20 g |

Meanwhile, the methane pyrolysis conditions performed in the rotary kiln-type reactor were set as shown in Table 2 below.

[Table 2]

| Classification | Pyrolysis conditions |
|---|---|
| Reaction temperature | 820°C |
| Reaction pressure | 1.4 bar |
| Flow rate of methane in gaseous feedstock | 1.5 slm |
| Feeding rate of catalysts | 46.9 cc/hr |
| Rotational speed of kiln (tube) | 0.2 rpm |
| Inclination angle of kiln | 1 ° |

The methane conversion as a function of the pyrolysis time (TOS, time on stream) was measured and the results are shown in FIG. 7.

As can be seen from the drawing, the maximum methane conversion was 92% at the reaction temperature and reaction pressure set under conditions in which the catalyst and methane were continuously fed, and at this time, no moisture was generated.

### B. Methane pyrolysis 2

The methane pyrolysis conditions performed in the horizontal tube reactor were set as shown in Table 3 below.

[Table 3]

| Classification | Pyrolysis conditions |
|---|---|
| Reaction temperature | 820°C |
| Reaction pressure | 1.4 bar |
| Flow rate of methane in gaseous feedstock | 3 slm |
| Feeding rate of catalysts | 59.5 cc/hr |
| Rotational speed of kiln (tube) | 0.13 rpm |
| Inclination angle of kiln | 0.5 ° |

The methane conversion as a function of the pyrolysis time (TOS, time on stream) was measured and the results are shown in FIG. 8. Compared to methane pyrolysis 1, production was increased by simultaneously increasing methane flow rate and catalyst feed rate while lowering the rotation speed of the rotary kiln-type reactor, and a methane conversion of up to 89% was achieved.

**C. Continuous production of hydrogen and iron-containing carbon (C/Fe) through methane pyrolysis**

The composition of the streams in the overall process shown in FIG. 1 based on a conversion of 90% during the pyrolysis under the same rotary kiln-type reactor and reaction conditions as in methane pyrolysis 2 is shown in Table 4 below (unit: tons).

[Table 4]

| Stream | Composition |
|---|---|
| Feedstock | $CH_4$: 14.9 |
| 1 | $CH_4$: 16 |
| 2 | $CH_4$: 16, iron ore: 1.72 |
| 3 | iron ore 1.72 |
| 4 | $CH_4$: 16, iron ore: 1.72 |
| 5 | $H_2/CH_4/CO$: 3.6/1.1/0.91 |
| 6 | $H_2/CH_4/CO$: 3.6/1.1/0.91 |
| 7 | $CH_4$: 1.1 |
| 8 | $H_2$: 3.6 |
| 9 | CO: 0.91 |
| 10 | $CH_4$: 1.1 |
| 11 | C/Fe: 10.8/1. 2 |

The results shown in Table 4 above indicate that the process was achieved in a continuous mode using methane as a feedstock and iron ore as a catalyst at a hydrogen production scale of 1 ton per year. Table 4 above shows the mass flow of hydrogen, carbon monoxide, and carbon produced according to the process flow when hydrogen is produced at a methane conversion by a catalyst of 90%.

The result of the analysis showed that the oxygen present in the iron ore was converted into carbon monoxide and removed, the activated iron reacted with methane and as carbon was deposited, the activated metal, iron and carbon were removed as solids, while gaseous hydrogen, carbon monoxide and unreacted methane can be easily separated through a subsequent separation process.

**Comparative Example 1**

No subsequent heat treatment was performed on the iron-containing carbon obtained through methane pyrolysis 1 and properties of the carbon are shown in Table 5 below.

**Comparative Example 2**

Heat treatment was performed at 1,800°C for 1 hour on the iron-containing carbon prepared according to Comparative Example 1. However, because, when analyzing the heat treatment product, iron impurities were not sufficiently removed, a separate analysis was not performed.

**Comparative Example 3**

Heat treatment was performed in the same manner as in Comparative Example 2, except that the heat treatment time was changed to 2 hours. The properties of the heat-treated product are shown in Table 5 below.

**Example 1**

In order to compare changes in the physical properties of carbon depending on heat treatment time at the same heat treatment temperature, the heat treatment time was increased from 0 to 6 hours. The iron-containing carbon prepared according to Comparative Example 1 was heat-treated at a temperature of 1,800°C for 6 hours. The properties of the heat-treated product are shown in Table 5 below.

[Table 5]

| Categor y | Temper ature (°C) | Time (hr) | Pore volume of micropor es and mesopore s ($cm^3/g$) | SSA ($N_2$) (mV / g) | C (TGA) (wt%) | $I_D/I_G$ (Rama n) | Lc (nm) |
|---|---|---|---|---|---|---|---|
| Example 1 | 1800 | 6 | 0.106 | 33.78 | 96.7 | 0.71 | 9 |
| Compara tive Example 1 | - | 0 | 0.092 | 30.06 | 90.0 | 1.34 | 11.0 |
| Compara tive Example 2 | 1800 | 1 | Not analyzed separately due to insufficient removal of iron impurities | | | | |
| Compara tive Example 3 | 1800 | 2 | N/A | N/A | 93.2 | 0.68 | 10.6 |

Comparing the properties according to Example 1 and Comparative Example 1 in Table above, the pore volume of micropores and mesopores before heat treatment (iron-containing carbon) was 0.092 $cm^3/g$, and after heat-treatment at 1,800°C for 6 hours, the pore volume increased to 0.106 $cm^3/g$. In addition, the size of the macropores increased from 110 nm before heat treatment to 130 nm after heat treatment, and the pore volume of the macropores changed from 0.39 $cm^3/g$ before heat treatment to 0.37 $cm^3/g$ after heat treatment.

In addition, the properties of the carbon-based material after heat treatment were affected by heat treatment time, and the decrease in d(002) lattice spacing in graphite carbon from 3.36 Å to 3.04 Å results from the increased crystallinity.

Furthermore, the result of Raman spectroscopy showed that the ratio $I_D/I_G$ decreased from 1.34 before heat treatment to 0.71 after heat treatment at 1,800°C for 6 hours. This means that the crystallinity of carbon increases as amorphous carbon decreases due to heat treatment.

- XRD analysis

The XRD patterns for the iron-containing carbon according to Comparative Example 1 and the porous carbon-based material obtained after heat treatment (1,800°C for 6 hours) according to Example 1 are shown in FIGS. 9A and 9B, respectively.

As can be seen from FIGS. 9A and 9B, as in Comparative Example 1, characteristic peaks of iron (Fe) along with carbon were observed before heat treatment, but characteristic peaks of iron were not observed after heat treatment.

- TGA analysis

The iron-containing carbon according to Comparative Example 1 was heat-treated at 1,800°C and then subjected to TGA under oxidization conditions to measure weight loss (%) and residual content as a function of temperature. The results of analysis using TGA equipment are shown in Table 6 below.

It can be seen from Table 6 above that, as the heat treatment time of iron-containing carbon increased, weight loss increased during TGA under oxidizing conditions. This means that impurities were removed from carbon by heat treatment. Even if the time of heat treatment at 1,800°C was increased to 8 hours, the weight loss was similar to the result of heat treatment for 6 hours. Based on this result, it would be preferable that the time of heat treatment at 1,800°C is set to 6 hours.

[Table 6]

| Heat treatment time | Weight loss (%) |
|---|---|
| No heat treatment | 87.2 |
| 1 hour | 89.7 |
| 2 hours | 90.1 |
| 6 hours | 97.6 |
| 8 hours | 97.2 |

- Analysis of changes in pore properties due to heat treatment

Changes in pore properties of carbon after heat treatment was performed at 1,800°C for 6 hours according to Comparative Example 1 (before heat treatment) and Example 1 were analyzed by physical nitrogen adsorption and mercury intrusion, and the results are shown in FIGS. 10A and 10B.

As can be seen from FIG. 10A, in carbon after heat treatment, the first maximum peak (maximum pore size distribution) was observed at 2.6 nm and the second maximum peak was observed at 3.9 nm. However, there was little change in the size of micropores and mesopores in pyrolyzed carbon due to heat treatment. However, through heat treatment, the pore volume of micropores and mesopores increased from 0.092 $cm^3/g$ to 0.106 $cm^3/g$.

Meanwhile, as can be seen from FIG. 10B, carbon after heat treatment had a first maximum peak (maximum pore size distribution) of 130 nm, which means that the size of the macropores increased. In addition, the pore volume of the macropore had little change from 0.39 $cm^3/g$ to 0.36 $cm^3/g$.

The results show that, regarding the physical properties of pores in methane-pyrolyzed carbon before and after heat treatment, micropores and mesopores had little change in size, while pore volumes thereof increased. Meanwhile, the size of macropores in carbon increased due to heat treatment, but the change in pore volume was slight. The reason for this is that the volume of micropores and mesopores increased as the iron oxide particles used as a catalyst during pyrolysis of methane were removed by heat treatment and the size of the macropores mainly formed as the channel between carbon and carbon increased as the crystallinity of the carbon structure increased.

**Example 3**

Analysis of the effect of methane pyrolysis temperature on the properties of porous carbon-based materials after heat treatment

The two types of iron-containing carbon produced at methane pyrolysis temperatures of 750°C (TL) and 850°C (THT) in the experiment of methane pyrolysis 1 were heat-heated at 2,700°C for 1 hour to remove various impurities including iron. In order to confirm quick removal of impurities in pyrolyzed carbon, the heat treatment temperature was increased to 2,700°C and the heat treatment time was shortened to 1 hour. High-resolution transmission electron microscopy (HRTEM) images (using Tecnai F30 from FEI) of the iron-containing carbon (THT) before and after heat treatment are shown in FIGS. 11A and 11B, respectively.

Referring to FIGS. 11A and 11B, it is observed that impurities in carbon were removed due to heat treatment.

**Example 4**

Preparation and analysis of silicon-carbon (Si/C) composite

A silicon-carbon (Si/C) composite was prepared from the porous carbon-based material obtained in Example 1 by deposition using silane ($SiH_4$) as a silicon source. Detailed conditions for silane deposition are as follows.

- Reactor and operation mode: Rotary kiln-type reactor, batch operation
- Silane concentration: 10% (v/v)
- Total gas flow rate: 500 SCCM ($N_2$ 450 SCCM, $SiH_4$ 50 SCCM)
- Amount of carbon loaded: 5 g
- Deposition time: 10 hours
- Deposition temperature: 500 °C

TEM-EDS and HRTEM analysis were performed on the silicon-carbon (Si/C) composite prepared under the conditions described above and the results are shown in FIGS. 12 and 13, respectively.

As can be seen from FIGS. 12 and 13, silicon having a size of 50 to 100 nm was deposited uniformly not only on the outside of the porous carbon-based material but also within the internal pores thereof. In addition, the result of ICP analysis of the silicon-carbon (Si/C) composite shows that the content of silicon in the composite was 50.7% by weight. It can be expected from the size of the deposited silicon that the silicon was deposited in the macropores of the porous carbon-based material.

Meanwhile, the high specific surface area of carbon in the silicon-carbon (Si/C) composite is known to be correlated with a high amount of deposited silicon. However, notably, in the porous carbon having all of micropores, mesopores, and macropores distributed therein, the amount of deposited silicon can be increased although macropores have a low specific surface area.

**Example 5**

Coin cell evaluation was performed using the silicon-carbon (Si/C) composite prepared according to Example 4. Here, anode material was prepared using a slurry containing 20% by weight of silicon-carbon (Si/C) composite and 2% by weight of a commercial binder. The electrochemical performance test of the prepared anode material was performed through a known charge/discharge test procedure and the results are shown in Table 7 below.

For comparison, the battery performance of coin cells manufactured in the same manner using commercial products was evaluated and the results are shown in Table 7 below.

[Table 7]

| Coin cell evaluation | Electrode with 20 wt% silicon-carbon (Si/C) composite | | | Electrode (single) | | |
|---|---|---|---|---|---|---|
| | Charging capacity (mAh/g) | Discharging capacity (mAh/g) | Initial efficiency | Charging capacity (mAh/g) | Initial efficiency (mAh/g) | Initial efficiency |
| Commercial product | 733 | 679 | 92.6% | 2111 | 1933 | 91.5% |
| Example 5 | 740 | 659 | 89.0% | 2115 | 1812 | 85.7% |

The value of the electrode (single) in Table 7 refers to a charging capacity when the silicon-carbon composite is used alone as anode material. The result of the measurement shows that the (converted) discharge capacity was about 1,812 mAh/g and the initial efficiency was 85.7%, which was 6.4% lower than that of commercial products.

However, pyrolytic carbon, which is a porous carbon-based material, has a graphite structure and thus may be used as an electrode at an increased mixing ratio thereof. In addition, economic feasibility can be improved by discovering the novel use of by-products obtained from the low-carbon hydrogen production process by methane pyrolysis as battery materials (for example, electrode materials for secondary batteries) since the porous carbon-based material is synthesized from pyrolyzed carbon, which is a by-product of hydrogen production.

As apparent from the foregoing, a silicon-carbon (Si/C) composite that can be utilized in various applications can be prepared by attaching (or depositing) silicon to a porous carbon-based material, from which iron impurities have been removed, obtained by heat-treating solid iron-containing carbon produced during methane pyrolysis using an iron-based catalyst. In particular, porous carbon derived from methane pyrolysis has at least three types of pore structures (micropores, mesopores and macropores) and has properties suitable for electrode materials, for example, anode materials, for various energy storage devices such as lithium-ion batteries. Furthermore, the silicon-carbon composite using porous carbon obtained from heat treatment has high economic value in that low-cost carbon can be used to produce high-value electrode materials, for example, because it exhibits electrochemical performance comparable to commercial electrode materials (for example, anode materials), which are by-products of the process of producing hydrogen from methane.

## Claims

1. A method for preparing a silicon-carbon (Si/C) composite comprising:

   a) providing solid iron-containing carbon separated from a product of methane pyrolysis performed in the presence of an iron-based catalyst;
   b) removing iron as an impurity from the solid iron-containing carbon by heat treatment to form a porous carbon-based material having increased micropore and mesopore volumes and an increased macropore size; and
   c) attaching silicon to the porous carbon-based material formed in step b).

2. The method of claim 1, wherein a content of the iron (on an elemental basis) in the iron-containing carbon is determined within a range of 0.1 to 20% by weight.

3. The method of claim 1 or 2, wherein the heat treatment in step b) is performed at a temperature of at least 1,600°C and at an atmospheric pressure or lower.

4. The method of any one of claims 1 to 3, wherein step a) comprises:

subjecting a methane-containing feedstock to pyrolysis in the presence of an iron-containing catalyst in the form of solid particles to form (i) a gas mixture containing hydrogen and (ii) solid iron-containing carbon as a combination of carbon produced by the pyrolysis with iron derived from the iron-based catalyst; and
separating the solid iron-containing carbon from the gas mixture.

**5.** The method of any one of claims 1 to 4, wherein step a) comprises:

a1) introducing the methane-containing feedstock along with the iron oxide-containing catalyst in the form of solid particles into a rotary kiln-type reactor to form a pyrolysis product containing unreacted methane, carbon, hydrogen and carbon monoxide; and
a2) separating the gas mixture containing unreacted methane, hydrogen and carbon monoxide, and the solid iron-containing carbon from the pyrolysis product, respectively through gas-solid phase separation.

**6.** The method of claim 5, wherein the methane-containing feedstock and the iron oxide-containing catalyst in the form of solid particles are introduced into the rotary kiln-type reactor in a co-current flow manner.

**7.** The process of claim 5, wherein the rotary kiln-type reactor comprises:

a tube configured to accommodate solid particles and gas and to be rotatable;
a heater configured to supply controlled heat to an inner space of the tube;
a helix baffle configured to extend along an inner circumferential surface of the tube to induce the introduced iron oxide-containing catalysts in the form of solid particles to move forward in a longitudinal direction of the tube according to rotation of the tube; and
at least one lifter provided on the inner circumferential surface of the tube to disperse the introduced iron oxide-containing catalysts in the form of solid particles in the tube.

**8.** The method of any one of claims 1 to 7, wherein a pore volume of the micropores and mesopores of the porous carbon-based material is within a range of 0.08 to 0.25 $cm^3/g$ and a pore size of the macropores thereof is within a range of 65 to 250 nm, and
a pore volume of the micropores and mesopores of the solid iron-containing carbon is within a range of 0.05 to 0.2 $cm^3/g$ and a pore size of the macropores thereof is within a range of 50 to 200 nm.

**9.** The method of any one of claims 1 to 8, wherein a ratio of $I_D/I_G$ of the solid iron-containing carbon upon Raman spectroscopy is at least 1.1, and
a ratio of $I_D/I_G$ of the porous carbon-based material upon Raman spectroscopy is 1 or less.

**10.** A silicon-carbon (Si/C) composite comprising:

a porous carbon-based material having an iron content of 20 mg/kg or less and having micropores, mesopores, and macropores; and
silicon attached to the porous carbon-based material,
wherein the porous carbon-based material has a graphite-type carbon structure,
a pore volume of the micropores and mesopores having a pore size within the range of 1.5 to 50 nm is within a range of 0.08 to 0.25 $cm^3/g$.

**11.** The silicon-carbon (Si/C) composite of claim 10, wherein a pore volume of the macropores having a size within a range of 65 to 250 nm is at least 0.1 $cm^3/g$.

**12.** The silicon-carbon (Si/C) composite of claim 10 or 11, wherein the micropores and the mesopores comprise a primary pore and a secondary pore,
wherein a size of the primary pore is within a range of 1.5 to 3.5 nm and a size of the secondary pore is within a range of 3.5 to 50 nm.

**13.** The silicon-carbon (Si/C) composite of any one of claims 10 to 12, wherein a thickness of silicon in the silicon-carbon (Si/C) composite is within a range of 10 to 200 nm.

**14.** An electrode material comprising the silicon-carbon (Si/C) composite according to any one of claims 10 to 13.

**15.** The electrode material according to claim 14, wherein the electrode material is anode material for batteries.

Fig. 1

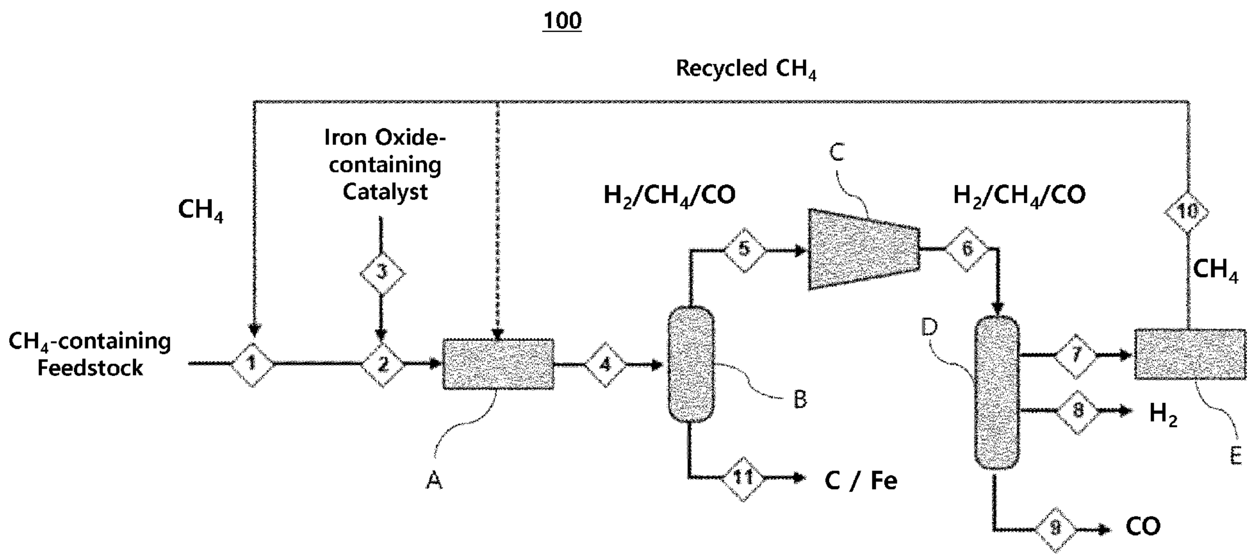
100
Recycled $CH_4$
Iron Oxide-containing Catalyst
$CH_4$
$H_2/CH_4/CO$
C
$H_2/CH_4/CO$
10
$CH_4$
3
5
6
$CH_4$-containing Feedstock
1
2
4
B
D
7
8
$H_2$
E
A
11
C / Fe
9
CO

Fig. 2

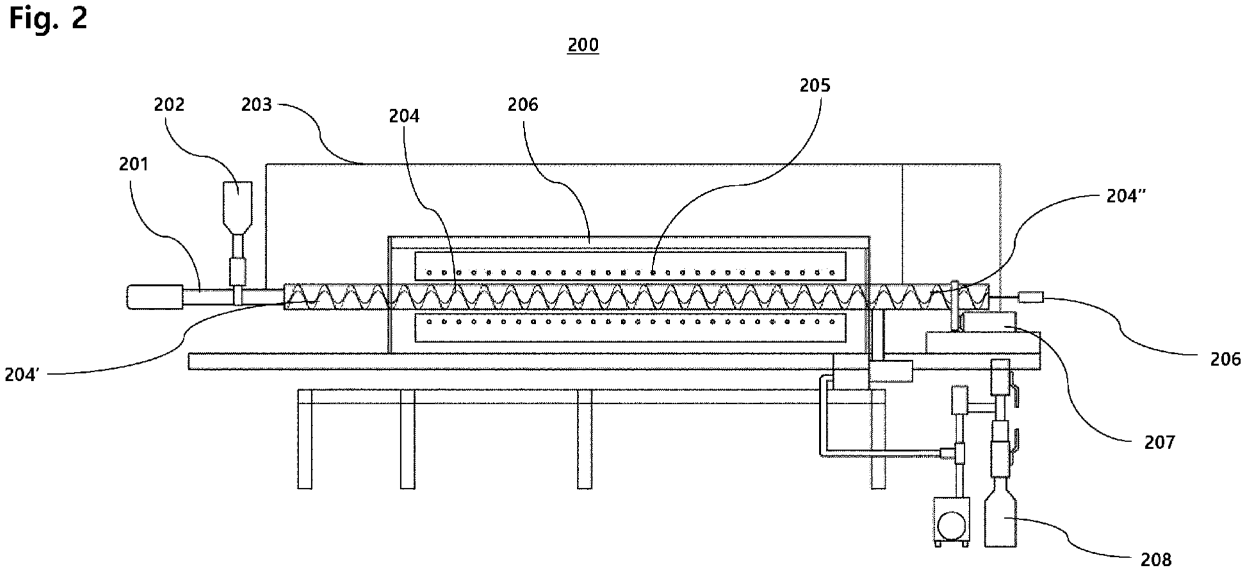

Fig. 3A

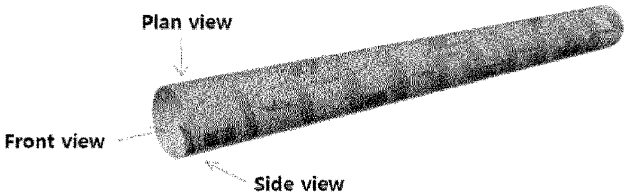


Fig. 3B

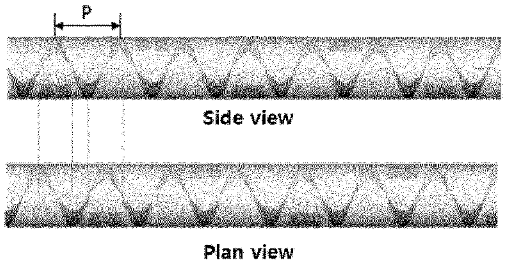


Fig. 3C

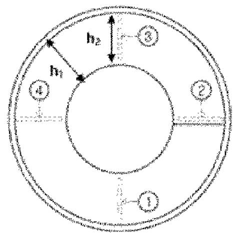


Front view

Fig. 4

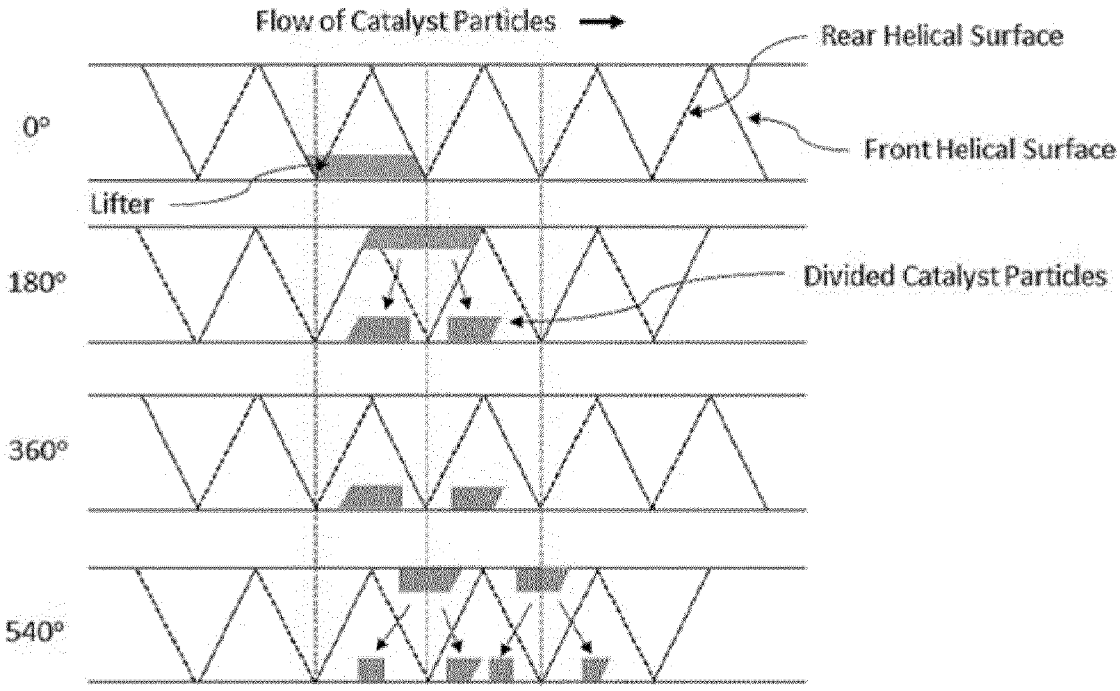
Flow of Catalyst Particles
Rear Helical Surface
0°
Front Helical Surface
Lifter
180°
Divided Catalyst Particles
360°
540°

Fig. 5A

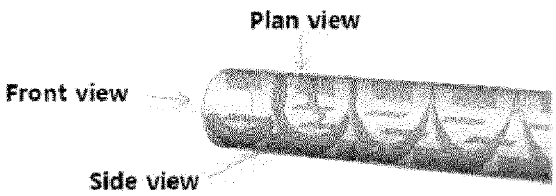


Fig. 5B

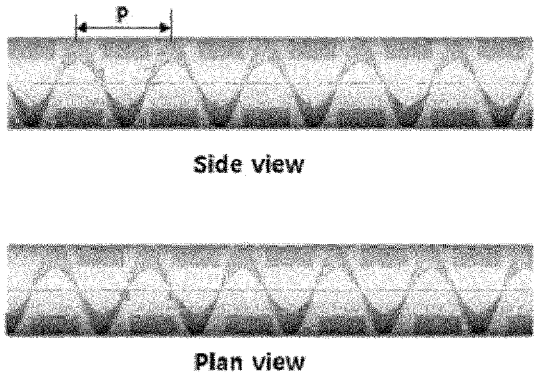


Fig. 5C

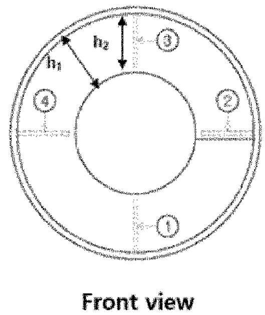

Fig. 6A

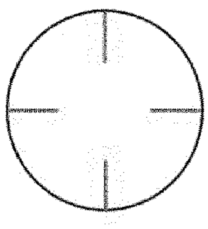

Fig. 6B

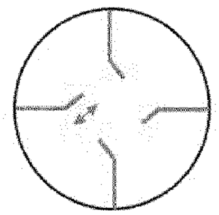

Fig. 6C

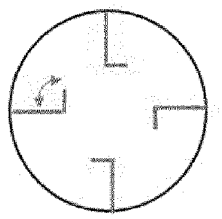

Fig. 7

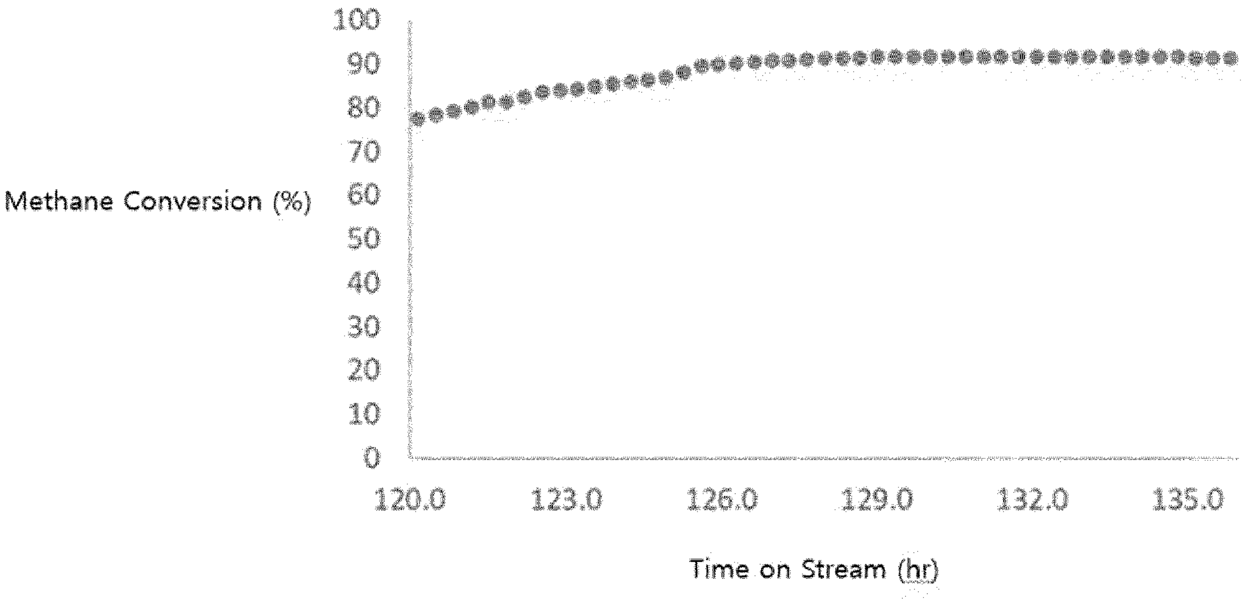
Methane Conversion (%)
100
90
80
70
60
50
40
30
20
10
0
120.0
123.0
126.0
129.0
132.0
135.0
Time on Stream (hr)

Fig. 8

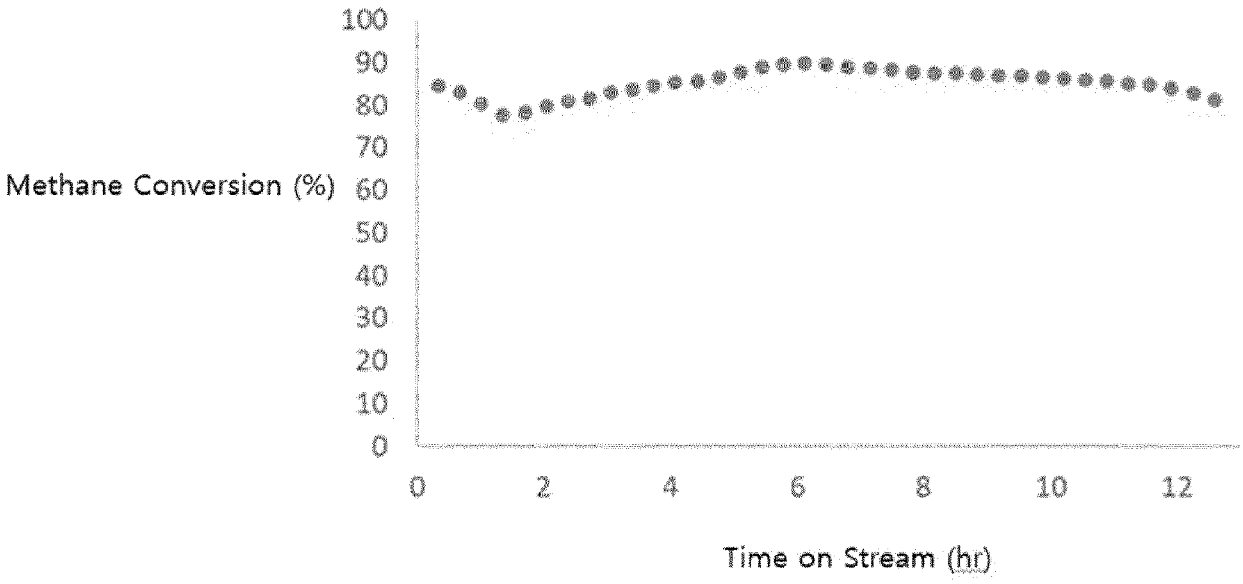
100
90
80
70
Methane Conversion (%)
60
50
40
30
20
10
0
0
2
4
6
8
10
12
Time on Stream (hr)

Fig. 9

(a) (b)

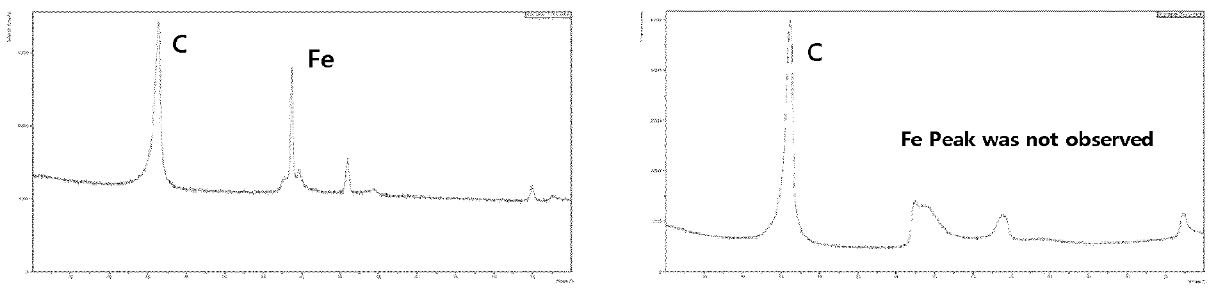

## Fig. 10

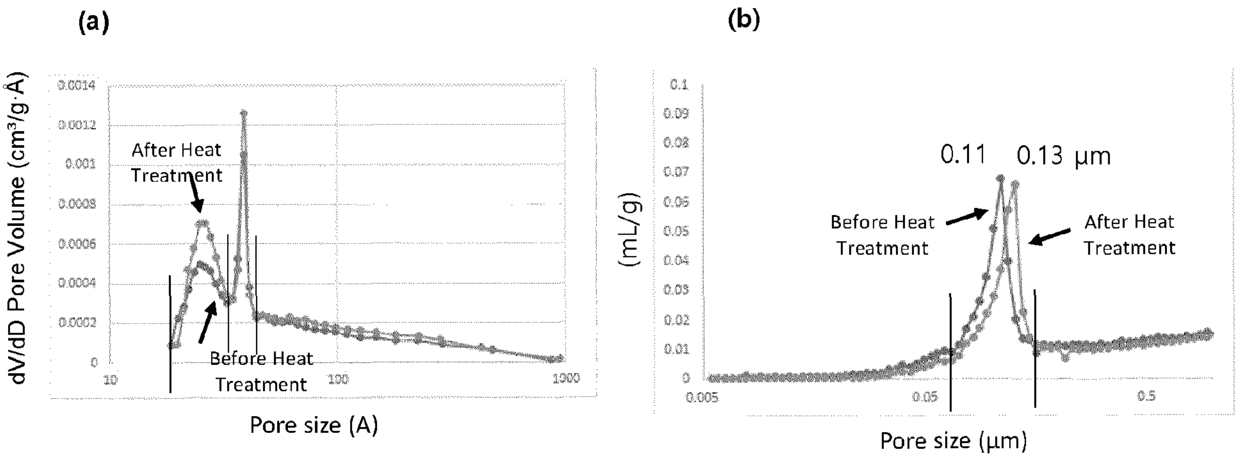
(a)
dV/dD Pore Volume (cm³/g·Å)
0.0014
0.0012
0.001
0.0008
0.0006
0.0004
0.0002
0
10
100
1000
After Heat Treatment
Before Heat Treatment
Pore size (A)
(b)
(mL/g)
0.1
0.09
0.08
0.07
0.06
0.05
0.04
0.03
0.02
0.01
0
0.005
0.05
0.5
0.11
0.13 μm
Before Heat Treatment
After Heat Treatment
Pore size (μm)

Fig. 11

(a) (b)

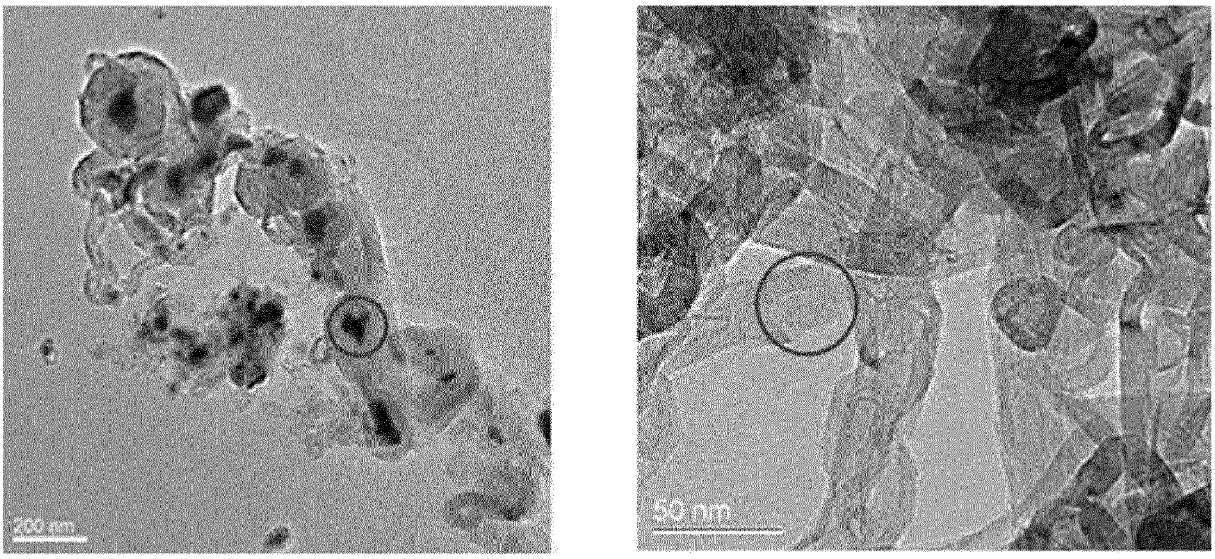

Fig. 12

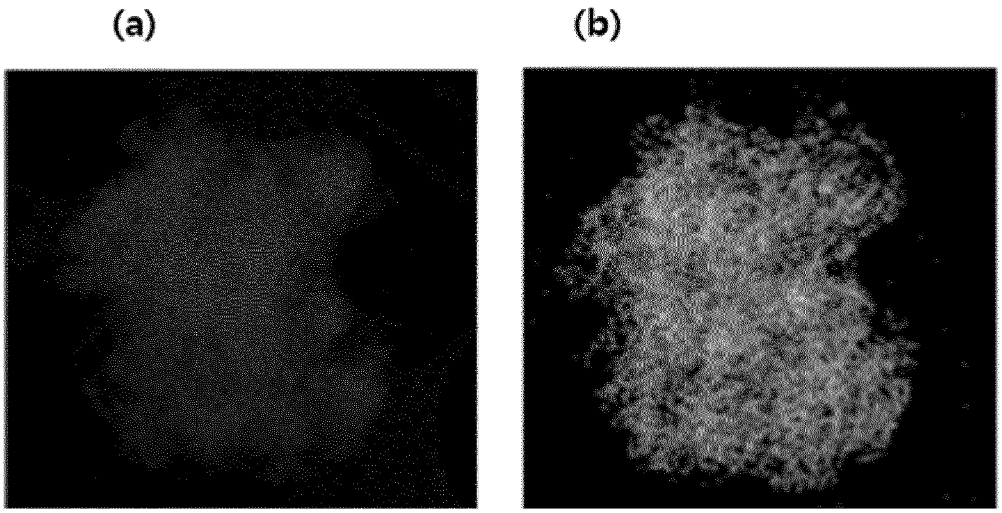

Fig. 13

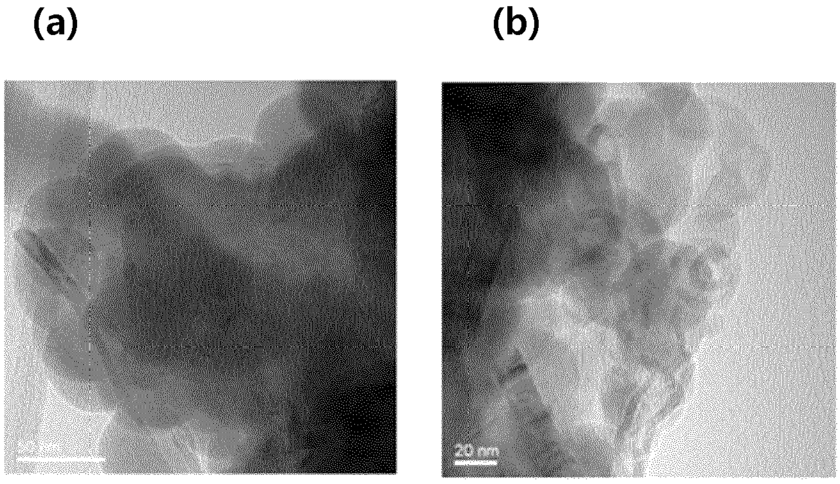

Europäisches Patentamt
European Patent Office
Office européen des brevets

# EUROPEAN SEARCH REPORT

Application Number
EP 24 16 5545

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | WO 2023/093893 A1 (LANXI ZHIDE ADVANCED MAT CO LTD [CN]) 1 June 2023 (2023-06-01)<br>* page 1 - page 47; claims 1-23; figures 1-14; tables 1-4 *<br>----- | 10-15<br>1-9 | INV.<br>C01B32/05<br>B82Y30/00<br>B82Y40/00<br>C01B32/312<br>C01B32/33<br>C01B32/348<br>C01B33/027<br>H01M4/04<br>H01M4/36<br>H01M4/38<br>H01M4/587<br>H01M4/62<br>H01M10/0525<br>H01M4/583<br><br>ADD.<br>H01M4/02 |
| Y<br><br><br><br><br><br><br><br><br><br><br><br><br><br>A | SUN CHUAN-FU ET AL: "Interfacial Oxygen Stabilizes Composite Silicon Anodes ¦ Nano Letters",<br>NANO LETTERS, [Online]<br>vol. 15, no. 1,<br>14 December 2014 (2014-12-14), pages 703-708, XP093200461,<br>US<br>ISSN: 1530-6984, DOI: 10.1021/nl504242k<br>Internet<br>Retrieved from the Internet:<br>URL:https://pubs.acs.org/doi/10.1021/nl504242k><br>[retrieved on 2024-08-30]<br>* page 703 - page 708 *<br>----- | 1-9<br><br><br><br><br><br><br><br><br><br><br><br><br><br>10-15 | |
| Y<br><br><br><br><br><br><br><br><br><br><br>A | Sun Chuan-Fu ET AL: "Interfacial Oxygen Stabilizes Composite Silicon Anodes",<br>,<br>19 December 2014 (2014-12-19), pages 1-16, XP093200457,<br>DOI: https://doi.org/10.1021/nl504242k<br>Retrieved from the Internet:<br>URL:https://pubs.acs.org/doi/suppl/10.1021/nl504242k/suppl_file/nl504242k_si_001.pdf<br>[retrieved on 2024-08-30]<br>* page 1 - page 16 *<br>-----<br>-/-- | 1-9<br><br><br><br><br><br><br><br><br><br><br>10-15 | TECHNICAL FIELDS SEARCHED (IPC)<br>C01B<br>H01M<br>B82Y |

The present search report has been drawn up for all claims

1

| Place of search | Date of completion of the search | Examiner |
|---|---|---|
| The Hague | 3 September 2024 | Konstantopoulos, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.........................................................................................
& : member of the same patent family, corresponding document

EPO FORM 1503 03.82 (P04C01)

page 1 of 2

Europäisches Patentamt
European Patent Office
Office européen des brevets

# EUROPEAN SEARCH REPORT

Application Number
EP 24 16 5545

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | HUANG W ET AL: "99.9% purity multi-walled carbon nanotubes by vacuum high-temperature annealing", CARBON, ELSEVIER OXFORD, GB, vol. 41, no. 13, 18 July 2003 (2003-07-18), pages 2585-2590, XP004458787, ISSN: 0008-6223, DOI: 10.1016/S0008-6223(03)00330-0 | 1-9 | |
| A | * page 2585 - page 2590 * | 10-15 | |
| | ----- | | |
| Y | AU 2022 256 114 A1 (SK INNOVATION CO LTD [KR]) 18 May 2023 (2023-05-18) | 1-9 | |
| A | * page 1 - page 64; claims 1-19 * | 10-15 | |
| | ----- | | |

TECHNICAL FIELDS SEARCHED (IPC)

The present search report has been drawn up for all claims

1

| Place of search | Date of completion of the search | Examiner |
|---|---|---|
| The Hague | 3 September 2024 | Konstantopoulos, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO.

EP 24 16 5545

This annex lists the patent family members relating to the patent documents cited in the above-mentioned European search report. The members are as contained in the European Patent Office EDP file on
The European Patent Office is in no way liable for these particulars which are merely given for the purpose of information.

03-09-2024

| Patent document cited in search report | Publication date | Patent family member(s) | Publication date |
|---|---|---|---|
| WO 2023093893 A1 | 01-06-2023 | EP 4343889 A1 | 27-03-2024 |
| | | JP 2024522950 A | 24-06-2024 |
| | | KR 20240113824 A | 23-07-2024 |
| | | US 2024290956 A1 | 29-08-2024 |
| | | WO 2023093893 A1 | 01-06-2023 |
| AU 2022256114 A1 | 18-05-2023 | AU 2022256114 A1 | 18-05-2023 |
| | | KR 20230061724 A | 09-05-2023 |
| | | US 2023133746 A1 | 04-05-2023 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 20180113448


### Non-patent literature cited in the description


- *Int. J. Hydrogen Energy*, vol. 18 (3), 211-215
- *Nanoscale*, 2014, vol. 6, 371-7